# EUROPÄISCHE PATENTSCHRIFT

(11) **EP 3 105 603 B1**
(45) Veröffentlichungstag und Bekanntmachung des Hinweises auf die Patenterteilung: **04.03.2020**
(21) Anmeldenummer: 15704789.5
(22) Anmeldetag: 13.02.2015
(51) Int. Cl.: G01R 33/00, G01R 33/02, G01R 33/09, G01B 7/30, H01L 43/02, H01L 43/08

(54) **3D MAGNETFELDSENSOR UND VERFAHREN ZU DESSEN HERSTELLUNG**
3D MAGNETIC FIELD SENSOR AND METHOD FOR PRODUCING SAME
CAPTEUR DE CHAMP MAGNÉTIQUE 3D ET SON PROCÉDÉ DE FABRICATION

(30) Priorität: 14.02.2014 DE 102014202770
(43) Veröffentlichungstag der Anmeldung: 21.12.2016
(73) Patentinhaber: Fraunhofer-Gesellschaft zur Förderung der angewandten Forschung e.V., 80686 München (DE)
(72) Erfinder: UEBERSCHÄR, Olaf, 04329 Leipzig (DE); ECKE, Ramona, 09112 Chemnitz (DE); SCHULZ, Stefan, 09120 Chemnitz (DE); MATTHES, Patrick, 09111 Chemnitz (DE); ALBRECHT, Manfred, 86150 Augsburg (DE)
(74) Vertreter: Zimmermann, Tankred Klaus
(86) Internationale Anmeldenummer: PCT/EP2015/053155
(87) Internationale Veröffentlichungsnummer: WO 2015/121447

(56) Entgegenhaltungen:
- EP-A1- 1 860 451
- EP-A1- 2 003 462
- US-A- 5 850 624
- US-A1- 2005 270 020
- US-A1- 2011 227 569
- US-A1- 2011 244 599
- US-A1- 2012 212 217
- US-A1- 2013 176 022
- US-A1- 2013 299 930

## Beschreibung

Die Erfindung bezieht sich auf einen dreidimensionale (3D) Magnetfeldsensor zur Erfassung von drei räumlichen Magnetfeldkomponenten und ein Verfahren zu dessen Herstellung. Die Erfindung bezieht sich ferner auf ein 3D Magnetfeldsensorsystem und ein 3D-Magnetfeldkamerasystem und insbesondere auf eine Magnetfeldkamera auf Basis dreiachsiger magnetoresistiver Sensoren mit integrierter Ausleseschaltung.

Bisher wurde die räumlich hoch aufgelöste elektronische Erfassung magnetischer Vektorfelder über ein Array von dreiachsigen Hall-Sensoren realisiert. Diesbezüglich wird auf die Veröffentlichungen [1] - [7] verwiesen.

Magnetfeldkameras mit dreiachsigen Hall-Sensoren können eine magnetischen Flussdichte ab ca. 1 mT erfassen. Eine Auflösung erfasster Sensorwerte beträgt gleichermaßen etwa 1 mT. Eine statische Winkelauflösung liegt dabei typischerweise zwischen ±5° bis ±8°. Aufgrund der endlichen Miniaturisierbarkeit der Hall-Sensoren begrenzt sich darüber hinaus die räumliche Auflösung derartiger Lösungen auf in etwa 100 µm. Andererseits schränkt die Auslesedauer des Hall-Sensorarrays von ca. 0,8 s die Zeitauflösung derartiger Lösungen auf größenordnungsmäßig 1 s ein.

Magnetfeldkameras mit Hall-Sensoren beruhen herstellungsbedingt auf einem Sensorarray mit einer Größe von 13 mm mal 13 mm. Das dadurch abbildbare Sichtfeld begrenzt sich damit auf eben diese Abmessungen.

Ein 3D Magnetfeldsensor ist z.B. aus US2011/0244599A1, US2013/0299930A1 sowie US2012/0212217A1 bekannt.

Eine Aufgabe der vorliegenden Erfindung besteht darin, ein Konzept zu finden, dass eine dreidimensionale Erfassung von Magnetfeldern mit einer hohen zeitlichen und räumlichen Auflösung ermöglicht.

Diese Aufgabe wird gelöst durch einen 3D Magnetfeldsensor gemäß dem Anspruch 1 oder 8, ein 3D Magnetfeldsensorsystem gemäß dem Anspruch 9 oder 15, ein 3D Magnetfeldkamerasystem gemäß dem Anspruch 13 und dem Verfahren zur Herstellung eines 3D Magnetfeldsensors gemäß dem Anspruch 14.

Weitere erfindungsgemäße Ausgestaltungen ergeben sich aus den Unteransprüchen.

Ein 3D Magnetfeldsensor zur Erfassung von drei räumlichen Magnetfeldkomponenten in einem Präferenzbereich umfasst eine erste, eine zweite und eine dritte magnetoresistive Sensorelementeanordnung. Die erste magnetoresistive Sensorelementeanordnung ist ausgebildet, eine erste Magnetfeldkomponente bezüglich einer ersten Raumachse und bezüglich des Referenzbereichs zu erfassen. Die zweite magnetoresistive Sensorelementeanordnung ist ausgebildet, um eine zweite Magnetfeldkomponente bezüglich einer zweiten Raumachse und bezüglich des Referenzbereichs zu erfassen. Die dritte magnetoresistive Sensorelementeanordnung ist ausgebildet, um eine dritte Magnetfeldkomponente bezüglich einer dritten Raumachse und bezüglich des Referenzbereichs zu erfassen. Jede der magnetoresistiven Sensorelementeanordnungen ist als Brückenschaltung mit einer Mehrzahl von magnetoresistiven Sensorelementen angeordnet. Die erste, zweite und dritte Raumachse verlaufen entlang linear unabhängiger Ortsvektoren im Raum.

Kerngedanke ist, dass mittels dreier Brückenschaltungen, drei von einander linear unabhängige Raumrichtungen eines Magnetfeldes erfassbar sind und dass eine Anordnung magnetoresistiver Sensorelemente als Komponenten der Brückenschaltungen eine hohe zeitliche Auflösung eines 3D Magnetfeldsensors ermöglicht. Ferner können die magnetoresistiven Sensorelemente so auf einem Substrat angeordnet werden, dass eine hohe räumliche Auflösung des 3D Magnetfeldsensors ermöglicht wird.

Vorteilhaft an diesen Ausführungsbeispielen ist, dass bei einer Verwendung von magnetoresistiven Sensorelementeanordnungen eine räumliche Auflösung entlang der Raumachsen hoch sein kann, beispielsweise in einem Größenbereich von etwa 10 µm. Ferner ermöglicht eine Anordnung der Sensorelemente in Brückenschaltungen eine Kompensation von parasitären Effekten, wie etwa Temperatureffekten.

Weitere Ausführungsbeispiele schaffen einen 3D Magnetfeldsensor, bei dem jede der Sensorelementeanordnungen einen geometrischen Mittelpunkt aufweist, der jeweils innerhalb des Referenzbereichs liegt, wobei die geometrischen Mittelpunkte in eine Bildebene projiziert deckungsgleich sind.

Vorteilhaft an diesem Ausführungsbeispiel ist, dass eine Erfassung der räumlichen Magnetfeldkomponenten jeweils symmetrisch zu den geometrischen Mittelpunkten bzw. zu dem Referenzbereich ermöglicht wird, so dass der jeweilige geometrische Mittelpunkt oder dessen Projektion in die Bildebene als ein Punkt oder ein Bereich mit einer Information bezüglich der räumlichen Magnetfeldkomponente in der jeweiligen Raumachse darstellbar ist. Deckungsgleiche geometrische Mittelpunkte ermöglichen eine Zuordnung der geometrischen Mittelpunkte zueinander, beispielsweise in Form einer Magnetfeldkarte oder eines Abbilds von Magnetfeldkomponenten.

Weitere Ausführungsbeispiele schaffen ein 3D Magnetfeldsensorsystem mit einem MxN Sensorarray, das eine Anzahl von MxN 3D Magnetfeldsensoren in Form einer Matrix mit M Zeilen und N Spalten und einem Substrat aufweist. Das 3D Magnetfeldsensorsystem umfasst ferner eine Ausleseschaltung zum Empfangen von Signalen der 3D Magnetfeldsensoren und eine Verbindungsstruktur, die mit dem MxN Sensorarray und der Ausleseschaltung verbunden ist.

Vorteilhaft an diesem Ausführungsbeispiel ist, dass eine Anordnung von 3D Magnetfeldsensoren in Form einer Matrix mit MxN 3D Magnetfeldsensoren eine Erfassung des Magnetfeldes bezüglich einer Anzahl von MxN Referenzbereichen entlang eines Sichtfeldes der Matrix ermöglicht. Es wird eine Erfassung des Magnetfeldes bezüglich der MxN Referenzbereiche zu einem Zeitpunkt ermöglicht, so dass Informationen bezüglich der Magnetfeldkomponenten entlang Abmessungen des MxN Sensorarrays zu einem Zeitpunkt bereitstellbar sind. Das Sensorarray kann aus einem Wafer gebildet sein, so dass eine Abmessung des Sensorarrays von einer Wafergröße abhängen kann. Dies ermöglicht Abmessungen des Sensorarrays mit Kantenlängen von beispielsweise 60 mm x 60 mm oder 180 mm x 180 mm. Dies kann einem Bildbereich des Magnetfeldsensorsystems entsprechen.

Weitere Ausführungsbeispiele schaffen ein 3D Magnetfeldsensorsystem, bei dem das Substrat des Sensorarrays oder die Verbindungsstruktur einstückig gebildet ist.

Vorteilhaft an diesen Ausführungsbeispielen ist, dass eine einstückige Ausbildung der Auswerteschaltung in dem Substrat und/oder eine einstückige Verbindungsschicht geringe Übergangswiderstände und mithin geringere elektrische und/oder thermische Verluste der Auswerteschaltung ermöglicht. Ferner kann eine zeitliche Auflösung des Magnetfeldsensorsystems gering sein, beispielsweise im Bereich von etwa einer Nanosekunde.

Weitere Ausführungsbeispiele schaffen 3D Magnetfeldsensorsysteme, bei denen ein Abstand zwischen Mittelpunkten der Referenzbereiche der MxN 3D Magnetfeldsensoren einen Wert von weniger als 50 µm zueinander aufweist.

Vorteilhaft an diesen Ausführungsbeispielen ist, dass 3D Magnetfeldsensorsysteme mit einer hohen räumlichen Auflösung des Magnetfeldsensorarrays realisierbar sind.

Weitere Ausführungsbeispiele schaffen 3D Magnetfeldkamerasysteme mit einem 3D Magnetfeldsensorsystem, das ferner eine Verarbeitungseinrichtung aufweist, die ausgebildet ist, um elektrische Signale von den Brückenschaltungen des Sensorarrays zu empfangen und, um basierend auf den elektrischen Signalen eine Information bezüglich der Magnetfeldorientierung in den drei Raumachsen für jeden der MxN 3D Magnetfeldsensoren bereitzustellen. Das Magnetfeldkamerasystem weist ferner eine Anzeigeeinrichtung auf, die ausgebildet ist, um eine Magnetfeldorientierung basierend auf der bereitgestellten Information darzustellen.

Vorteilhaft an diesem Ausführungsbeispiel ist, dass das erfasste Magnetfeld erfasst, dargestellt und/oder aufgezeichnet werden kann. Das 3D Magnetfeldkamerasystem kann beispielsweise eine mobile Anzeigeeinrichtung im Sinne einer Digitalkamera sein, etwa wenn die Information mit einem Monitor dargestellt wird.

Weitere Ausführungsbeispiele schaffen Verfahren zum Herstellen eines 3D Magnetfeldsensors. Die Verfahren umfassen ein Bereitstellen eines Substrats und ein Herstellen einer ersten magnetoresistiven Sensorelementeanordnung mit zumindest vier magnetoresistiven Sensorelementen in Form einer ersten Vollbrückenschaltung zur Erfassung einer ersten Magnetfeldkomponente bezüglich einer ersten Raumachse auf dem Substrat. Die Verfahren umfassen ferner ein Herstellen einer zweiten magnetoresistiven Sensorelementeanordnung mit zumindest vier magnetoresistiven Sensorelementen in Form einer zweiten Vollbrückenschaltung zur Erfassung einer zweiten Magnetfeldkomponente bezüglich einer zweiten Raumachse auf dem Substrat und ein Herstellen einer dritten magnetoresistiven Sensorelementeanordnung mit zumindest vier magnetoresistiven Sensorelementen in Form einer dritten Vollbrückenschaltung zur Erfassung einer dritten Magnetfeldkomponente bezüglich einer dritten Raumachse auf dem Substrat, wobei die Raumachsen entlang linear unabhängiger Ortsvektoren im Raum verlaufen.

Bevorzugte Ausführungsbeispiele der vorliegenden Erfindung werden nachfolgend Bezug nehmend auf die beiliegenden Zeichnungen näher erläutert. Es zeigen:
- Fig. 1: eine schematische Aufsicht auf einen (3D) Magnetfeldsensor gemäß einem Ausführungsbeispiel der vorliegenden Erfindung;
- Fig. 2a: eine schematische Aufsicht auf einen 3D Magnetfeldsensor mit GMR (GMR = Giant Magnetoresistance = Riesenmagnetwiderstand)-Sensorelementen gemäß einem Ausführungsbeispiel der vorliegenden Erfindung;
- Fig. 2b: eine schematische Aufsicht auf einen weiteren 3D Magnetfeldsensor mit TMR (TMR = Tunnel Magnetoresistance = Tunnelmagnetwiderstand)-Sensorelementen gemäß einem weiteren Ausführungsbeispiel der vorliegenden Erfindung;
- Fig. 3: eine schematische graphische Darstellung dreier geometrischer Mittelpunkte, die gegenüber geometrischen Mittelpunkten aus Fig. 2a einen lateralen Versatz entlang der x-, und y-Richtung aufweisen, gemäß einem Ausführungsbeispiel der vorliegenden Erfindung;
- Fig. 4: eine schematische Darstellung von geometrischen Mittelpunkten, die in verschiedenen Ebenen entlang einer Achse angeordnet sind, gemäß einem Ausführungsbeispiel der vorliegenden Erfindung;
- Fig. 5a: eine schematische Aufsicht auf ein 3D Magnetfeldsensorsystem, das eine Anzahl von MxN 3D Magnetfeldsensoren in einem MxN Sensorarray aufweist, die in einer Matrix mit M Zeilen und N Spalten angeordnet sind, gemäß einem Ausführungsbeispiel der vorliegenden Erfindung;
- Fig. 5b: eine vergrößerte Ansicht eines Teilbereichs des Sensorarrays aus Fig. 5a;
- Fig. 5c: eine schematische Seitenschnittansicht eines Ausschnitts des Sensorarrays, gemäß einem Ausführungsbeispiel der vorliegenden Erfindung;
- Fig. 6: eine schematische Aufsicht auf einen Wafer mit einem MxN Sensorarray, gemäß einem Ausführungsbeispiel der vorliegenden Erfindung;
- Fig. 7: eine schematische Seitenschnittansicht eines beispielhaften Schichtstapels mit einer planaren magnetischen Anisotropie; und
- Fig. 8: ein schematisches Ablaufdiagramm eines Verfahrens zum Herstellen eines 3D Magnetfeldsensors gemäß einem Ausführungsbeispiel der vorliegenden Erfindung.

Unter den Begriff "xMR-Struktur" sollen in der folgenden Beschreibung alle bekannten magnetoresistiven Strukturen fallen, wie z. B. AMR-Strukturen (AMR = Anisotropic Magnetoresistance = anisotroper Magnetwiderstand), GMR-Strukturen (GMR = Giant Magnetoresistance = Riesenmagnetwiderstand), CMR-Strukturen (CMR = Colossal Magnetoresistance = kolossaler Magnetwiderstand), TMR-Strukturen (TMR = Tunnel Magnetoresistance = Tunnelmagnetwiderstand) oder EMR-Strukturen (EMR = Extraordinary Magnetoresistance = außerordentlicher Magnetwiderstand). In technischen Anwendungen von GMR-Sensoranordnungen werden heute vorzugsweise sogenannte Spin-Valve-Strukturen (Spin-Ventil-Strukturen) verwendet.

In der Sensorik werden gegenwärtig GMR-Strukturen (GMR = Giant Magnetoresistance) als auch TMR-Strukturen bzw. TMR-Schichtsysteme eingesetzt. Bei einer elektrischen Kontaktierung unterscheidet man zwischen einer CIP-Konfiguration (CIP = current in plane) und einer CPP-Konfiguration (CPP = current perpendicular to plane). Bei der CIP-Konfiguration wird das Schichtsystem von einer Seite her kontaktiert und der Stromfluss erfolgt parallel zum Schichtsystem, währenddessen bei der CPP-Konfiguration das Schichtsystem von zwei Seiten kontaktiert wird, so dass der Stromfluss senkrecht zum Schichtsystem erfolgt. GMR-Schichtsysteme werden üblicherweise in der CIP-Konfiguration betrieben, was wegen einer erforderlichen Kontaktierung von nur einer Seite an ein Schichtpaket oder an einer Schichtstruktur prozesstechnisch mit verhältnismäßig geringem Aufwand verbunden ist. Auch lassen sich so auf einfache Art und Weise technisch günstige Widerstandswerte im Bereich von z. B. einigen Kiloohm alleinig unter Verwendung eines einfachen Schichtsystems (mit Dicke z. B. im Nanometerbereich) einstellen.

Bevor nachfolgend Ausführungsbeispiele der vorliegenden Erfindung im Detail anhand der Zeichnungen näher erläutert werden, wird darauf hingewiesen, dass identische, funktionsgleiche oder gleichwirkende Elemente, Objekte und/oder Strukturen in den unterschiedlichen Figuren mit den gleichen Bezugszeichen versehen sind, so dass die in unterschiedlichen Ausführungsbeispielen dargestellte Beschreibung dieser Elemente untereinander austauschbar ist bzw. aufeinander angewendet werden kann.

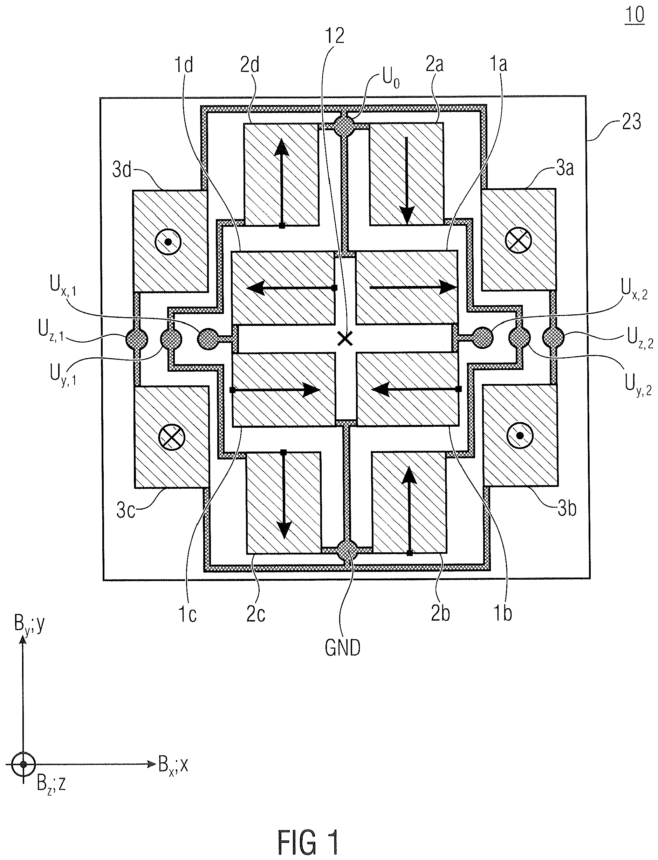

Fig. 1 zeigt eine schematische Aufsicht auf einen dreidimensionalen (3D) Magnetfeldsensor 10 gemäß einem Ausführungsbeispiel der vorliegenden Erfindung. Der 3D Magnetfeldsensor 10 ist ausgebildet, um drei räumliche Magnetfeldkomponenten Bₓ, B_{y} und B_{z} bezüglich eines Referenzbereichs 12 zu erfassen.

Eine erste magnetoresistive Sensorelementeanordnung umfasst vier erste xMR-Sensorelemente 1a-d, die zu einer Vollbrückenschaltung gekoppelt sind. Die erste magnetoresistive Sensorelementeanordnung ist ausgebildet, um die erste Magnetfeldkomponente Bₓ bezüglich einer ersten Raumachse x und bezüglich des Referenzbereichs 12 zu erfassen.

Eine zweite magnetoresistive Sensorelementeanordnung des 3D Magnetfeldsensors 10 umfasst vier zweite xMR-Sensorelemente 2a-d zur Erfassung einer zweiten Magnetfeldkomponente B_{y} bezüglich einer zweiten Raumachse y und bezüglich des Referenzbereichs 12. Die zweiten xMR-Sensorelemente 16a-d sind ebenfalls zu einer Vollbrückenschaltung gekoppelt.

Der 3D Magnetfeldsensor 10 umfasst eine dritte magnetoresistive Sensorelementeanordnung mit vier zu einer Vollbrücke gekoppelten dritten xMR-Sensorelementen 3a-d zur Erfassung einer dritten Magnetfeldkomponente B_{z} bezüglich einer dritten Raumachse z und bezüglich des Referenzbereichs 12.

Die drei Raumrichtungen weisen beispielhaft in die x-, y- bzw. z-Richtung, wobei eine Zeichnungs- oder Betrachtungsebene der Fig. 1 in der x/y-Ebene dargestellt ist und die z-Richtung senkrecht aus der Zeichnungsebene heraus, d. h. in eine durch die x/y-Ebene definierte Raumhälfte in Richtung eines Betrachters weist. Die Richtung einer z-Achse (z-Richtung) ist durch den umrandeten Kreis im Schnittpunkt der x-Achse und der y-Achse angedeutet. Die Raumrichtungen x, y und z verlaufen entlang linear unabhängiger Ortsvektoren im Raum. Beispielsweise können die Raumachsen x, y und z ein kartesisches Koordinatensystem aufspannen und einen rechten Winkel zueinander aufweisen. Alternativ können die Achsen x, y und/oder z auch einen anderen Winkel zueinander aufweisen. Alternativ ist ebenfalls vorstellbar, dass die drei Raumrichtungen einen Winkel von ungleich 90° und ungleich 0° zueinander aufweisen.

Die Sensorelementeanordnungen bzw. die Brückenschaltungen und mithin die xMR-Sensorelemente 1a-d, 2a-d und 3a-d sind an einer Sensorebene 23 angeordnet.

Der Referenzbereich 12 kann beispielsweise eine Fläche aufweisen, die einem Wert von beispielsweise 100%, mehr als 50% oder mehr als 25% einer Fläche der Sensorebene 23 entspricht, welche von den Brückenschaltungen bedeckt wird. In einem Idealfall kann der Referenzbereich ein Punkt sein. Der Referenzbereich 12 kann bspw. ein Mittelpunkt eines Bildelementes (engl.: picture element - Pixel) sein, wobei eine Fläche des Pixels von der Fläche der Sensorebene 23 zumindest teilweise beeinflusst sein kann oder dieser entsprechen kann. Alternativ kann das Pixel bspw. auch eine Fläche aufweisen, die von einer Brückenschaltung der magnetoresistiven Sensorelemente 3a-d umschlossen ist.

Die Fläche des Pixels kann dabei so klein realisiert werden, dass eine räumliche Verteilung der Magnetfeldkomponenten Bₓ, B_{y} und/oder B_{z} über die Fläche des Pixels als gleichmäßig oder konstant angenommen werden kann.

Jede der Vollbrückenschaltungen weist vier Potentialabgriffe auf, die je zu zwei gegenüberliegenden (das heißt zwischen zwei Sensorelementen 1a-d, 2a-d bzw. 3a-d liegenden) Kontaktpaaren zusammenfassbar sind. Ein erstes Kontaktpaar weist die elektrischen Potentiale U₀ und eine Referenzspannung, bspw. 0 Volt bzw. Masse (engl.: Ground; GND) auf. Eine Versorgungsspannung mit einem elektrischen Potential U₀-GND ist an den drei Brückenschaltungen anlegbar, so dass die drei Brückenschaltungen mit einer gleichen Versorgungsspannung betreibbar sind. An dem jeweils verbleibenden Kontaktpaar sind Potentiale U_{x,1} und U_{x,2}, U_{y,1} und U_{y,2} bzw. U_{z,1} und U_{z,2} abgreifbar.

Eine angenommene Gleichmäßigkeit oder Konstanz kann beispielsweise daraus resultieren, dass eine räumliche Magnetfeldkomponente, etwa die Komponente B_{z}, an vier Orten oder Bereichen der dritten xMR-Sensorelemente 3a-d erfasst wird. Eine elektrische Potentialdifferenz U_{z,1}-U_{z,2} liefert beispielsweise basierend auf den vier Sensorelementen einen Spannungswert. Das bedeutet, dass Änderungen der Widerstandswerte der vier dritten xMR-Sensorelemente 3a-d in einer Potentialdifferenz zusammengefasst werden können, wobei die Potentialdifferenz Aufschluss darauf liefern kann, welche Stärke, Amplitude oder Änderung der Magnetfeldkomponente, beispielsweise B_{z} aufweist. Das bedeutet, dass die eine Potentialdifferenz, etwa U_{z,1}-U_{z,2} Aufschluss über die Magnetfeldkomponente innerhalb eines Bereichs, der durch die jeweiligen xMR-Sensorelemente aufgespannt wird, als homogen angenommen werden kann.

Die xMR-Sensorelemente 1a-d, 2a-d und 3a-d können alternativ oder zusätzlich veränderliche Widerstände basierend auf anderen xMR-Effekten, wie etwa dem GMR-, dem TMR-Effekt oder dem AMR-Effekt aufweisen.

Vorteilhaft an diesem Ausführungsbeispiel ist, dass mittels eines 3D Magnetfeldsensors unter Ausnutzung eines magnetoresistiven Effektes Magnetfeldkomponenten in drei Raumrichtungen erfassbar sind. Ein Bauraumbedarf, etwa eine laterale Abmessung des 3D Magnetfeldsensors 10 in der x-Richtung und/oder der y-Richtung kann verglichen mit Hall-Sensoren wesentlich geringer sein. Während Hall-Sensoren beispielsweise eine laterale Ausdehnung von zumindest 100 µm und mithin einem Flächenbedarf von 100² µm² aufweisen können, kann ein 3D Magnetfeldsensor gemäß Ausführungsbeispielen eine Abmessung von weniger als 50, weniger als 20 oder weniger als 10 µm und mithin einen Flächenbedarf von weniger als 50² µm², 20² µm² oder 10² µm² aufweisen.

Ein 3D Magnetfeldsensor wird nachfolgend beispielhaft anhand eines 3D Magnetfeldsensors mit GMR-Sensorelementen und anschließend anhand eines 3D Magnetfeldsensors mit TMR-Sensorelementen erläutert.

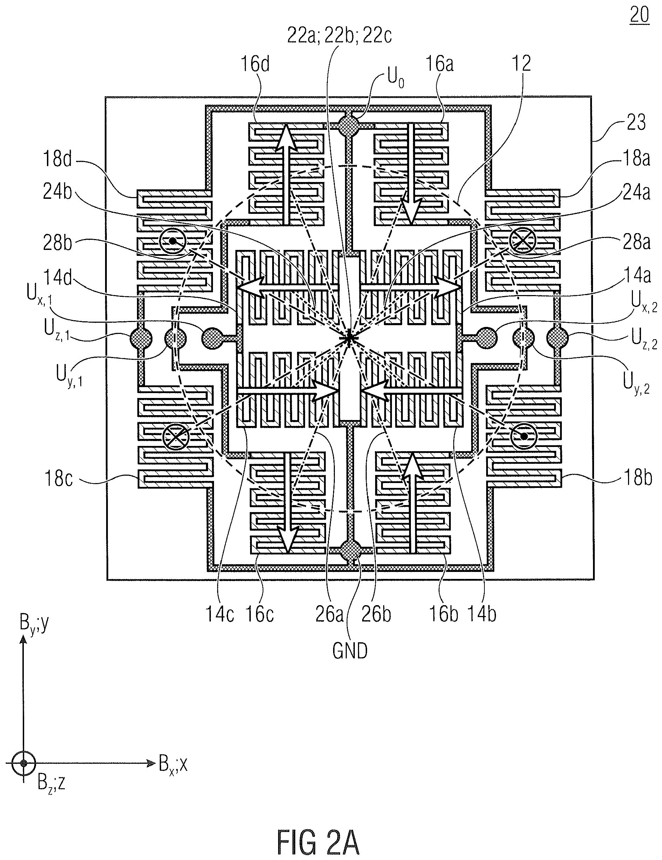

Fig. 2a zeigt eine schematische Aufsicht auf einen dreidimensionalen (3D) Magnetfeldsensor 20 gemäß einem Ausführungsbeispiel der vorliegenden Erfindung. Der 3D Magnetfeldsensor 20 ist ausgebildet, um drei räumliche Magnetfeldkomponenten Bₓ, B_{y} und B_{z} bezüglich eines Referenzbereichs 12 zu erfassen.

Eine erste magnetoresistive Sensorelementeanordnung umfasst vier erste GMR-Sensorelemente 14a-d, die zu einer Vollbrückenschaltung gekoppelt sind. Die erste magnetoresistive Sensorelementeanordnung bzw. die ersten GMR-Sensorelemente 14a-d sind ausgebildet, um die erste Magnetfeldkomponente Bₓ bezüglich einer ersten Raumachse x und bezüglich des Referenzbereichs 12 zu erfassen. Eine zweite magnetoresistive Sensorelementeanordnung umfasst vier zweite GMR-Sensorelemente 16a-d zur Erfassung einer zweiten Magnetfeldkomponente B_{y} bezüglich einer zweiten Raumachse y und bezüglich des Referenzbereichs 12. Die zweiten GMR-Sensorelemente 16a-d sind ebenfalls zu einer Vollbrückenschaltung gekoppelt. Der 3D Magnetfeldsensor 20 umfasst eine dritte magnetoresistive Sensorelementeanordnung mit vier zu einer Vollbrücke gekoppelten dritten GMR-Sensorelementen 18a-d zur Erfassung einer dritten Magnetfeldkomponente B_{z} bezüglich einer dritten Raumachse z und bezüglich des Referenzbereichs 12.

Wie es durch eine Pfeilrichtung an dem jeweiligen Sensorelement angedeutet ist, weisen die GMR-Sensorelemente 14a und 14c eine magnetische Vorspannung in eine positive x-Richtung auf. Die GMR-Sensorelemente 14b und 14d weisen eine magnetische Vorspannung in eine negative x-Richtung auf. Die GMR-Sensorelemente 16b und 14d weisen eine magnetische Vorspannung in eine positive y-Richtung auf. Die GMR-Sensorelemente 16a und 16c weisen eine magnetische Vorspannung in eine negative y-Richtung auf. Die GMR-Sensorelemente 18a und 18c weisen eine magnetische Vorspannung in eine positive z-Richtung auf, wie es durch die Symbole eines in die Ebene weisenden Pfeiles angedeutet ist. Die GMR-Sensorelemente 18b und 18d weisen eine magnetische Vorspannung in eine negative z-Richtung auf, wie es durch die aus der Betrachtungsebene herausweisenden Pfeile angedeutet ist. Eine Stromrichtung der GMR-Sensorelemente 14a-d, 16a-d und 18a-d entspricht dabei einer CIP-Konfiguration (CIP = current in plane).

Der 3D Magnetfeldsensor 20 ist ausgebildet, um bei einer angelegten Versorgungsspannung U₀-GND basierend auf einer erfassten Magnetfeldkomponente in x-Richtung veränderliche Potentiale U_{x,1} und U_{x,2} aufzuweisen. Selbiges gilt für die beiden anderen Raumrichtungen y und z bzw. die Potentiale U_{y,1} und U_{y,2} bzw. U_{z,1} und U_{z,2}.

Die ersten GMR-Sensorelemente 14a-d, die zweiten GMR-Sensorelemente 16a-d und die dritten GMR-Sensorelemente 18a-d und mithin die jeweiligen Brückenschaltungen weisen eine mäanderförmige Struktur mit einer lateralen Ausdehnung, beispielsweise in der x/y-Ebene auf. Die x/y-Ebene kann bspw. in einer Hauptseite einer Sensorebene 23 angeordnet sein, an der die GMR-Sensorelemente 14a-d, 16a-d und 18a-d angeordnet sind. Jede der Brückenschaltungen weist einen geometrischen Mittelpunkt 22a, 22b bzw. 22c auf. Die Brückenschaltungen und mithin die GMR-Sensorelemente 14a-d, 16a-d und 18a-d sind so angeordnet, dass die jeweiligen geometrischen Mittelpunkte 22a, 22b oder 22c innerhalb des Referenzbereichs 12 angeordnet sind.

Der Referenzbereich 12 kann somit durch eine Fläche, die von einer größten Brückenschaltung, etwa die Brückenschaltung der dritten GMR-Sensorelemente 18a-d, aufgespannt wird oder beispielsweise der kleinsten Brückenschaltung, etwa die Brückenschaltung, die durch die ersten GMR-Sensorelemente 14a-d aufgespannt wird, zumindest teilweise bestimmt werden. Alternativ kann der Referenzbereich 12 auch ein Wert dazwischen sein. Alternativ kann der Referenzbereich 12 auch um einen geometrischen Mittelpunkt (22a, 22b oder 22c) mit einem gewissen Radius, etwa 5 µm, 10 µm oder 30 µm definiert sein.

Die geometrischen Mittelpunkte 22a, 22b und 22c können deckungsgleich sein, etwa wenn die drei Brückenschaltungen in einer Ebene gebildet sind. Sind die Brückenschaltungen in unterschiedlichen Ebenen gebildet, können die geometrischen Mittelpunkte 22a, 22b und 22c beispielsweise deckungsgleich sein, wenn sie in eine Ebene, beispielsweise eine Bildebene, die parallel zu der Sensorebene 23 verläuft, projiziert werden.

Die geometrischen Mittelpunkte 22a, 22b und 22c können beispielsweise durch Schnittpunkte von Geraden 24a und 24b, 26a und 26b bzw. 28a und 28b definiert sein. Die Geraden 24a und 24b können so im Raum angeordnet sein, dass sie je zwei bezüglich einer jeweiligen Brückenschaltung diagonal gegenüberliegende geometrische Mittelpunkte, Körper- oder Flächenschwerpunkte der ersten GMR-Sensorelemente 14a-d verbinden und sich in einem Schnittpunkt, dem geometrischen Mittelpunkt 22a, schneiden. Selbiges gilt für die Geraden 26a und 26b im Hinblick auf die zweiten GMR-Sensorelemente 16a-d und den geometrischen Mittelpunkt 22b sowie für die Linien 28a und 28b im Hinblick auf die dritten GMR-Sensorelemente 18a-d und den geometrischen Mittelpunkt 22c.

Vorteilhaft an diesem Ausführungsbeispiel ist, dass eine Abscheidung eines GMR-Schichtstapels mit einem geringen Fertigungsaufwand realisierbar ist.

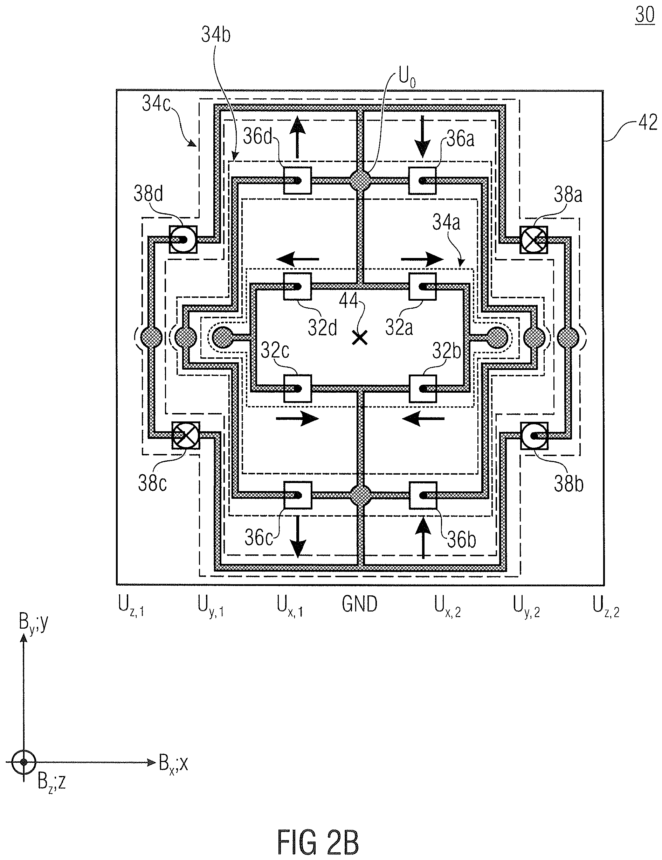

Fig. 2b zeigt eine schematische Aufsicht auf einen 3D Magnetfeldsensor 30 gemäß einem weiteren Ausführungsbeispiel der vorliegenden Erfindung. Der 3D Magnetfeldsensor 30 weist vier erste TMR-Sensorelemente 32a-d auf, die zu einer ersten Brückenschaltung 34a gekoppelt sind. Der 3D Magnetfeldsensor 30 weist ferner vier zweite TMR-Sensorelemente 36a-d auf, die zu einer zweiten Brückenschaltung 34b gekoppelt sind. Der 3D Magnetfeldsensor 30 weist ferner vier dritte TMR-Sensorelemente 38a-d auf, die zu einer dritten Brückenschaltung 34c gekoppelt sind. Die TMR-Elemente 32a-d, 36a-d und 36a-d weisen eine flächige, das heißt eine durchgehende bzw. massive Struktur auf.

In anderen Worten sind die Brückenschaltungen 34a-c von innen nach außen umschließend, das heißt geschachtelt, angeordnet.

Eine Sensitivität des jeweiligen TMR-Sensorelementes 32a-d, 36a-d und 38a-d bezüglich der Magnetfeldkomponenten Bₓ, B_{y} und B_{z} ist durch Pfeile benachbart zu dem jeweiligen TMR-Sensorelement angedeutet. Die TMR-Elemente 32a-d, 36a-d und 38a-d weisen die CPP-Konfiguration (CPP = current perpendicular to plane) auf. Die TMR-Sensorelemente 32a-d, 36a-d und 38a-d sind ausgebildet, um basierend auf einem zu erfassenden Magnetfeld einen ohmschen Widerstandswert zu ändern.

Die erste, innere Brückenschaltung 34a ist ausgebildet, um die räumliche Magnetfeldkomponente in der x-Richtung zu erfassen. Die zweite, mittlere Brückenschaltung 34b ist ausgebildet, um die räumliche Magnetfeldkomponente in der y-Richtung zu erfassen. Die dritte, äußere Brückenschaltung 34c ist ausgebildet, um die räumliche Magnetfeldkomponente in der z-Richtung zu erfassen. Alternativ kann eine Zuordnung einer räumlichen Magnetfeldkomponente in der x-, y- oder z-Richtung beliebig erfolgen, beispielsweise kann die Brückenschaltung 34c ausgebildet sein, um basierend auf veränderten Sensitivitätsrichtungen die räumliche Magnetfeldkomponente in der x-Richtung zu erfassen.

Die Brückenschaltungen 34a-c sind in einer Sensorebene 42 angeordnet. Die Sensorebene 42 kann beispielsweise wie die Sensorebene 23 und/oder von einem Substrat, an dem die Brückenschaltungen 34a-c angeordnet sind, gebildet sein. Die Brückenschaltungen 34a-c sind symmetrisch um einen geometrischen Mittelpunkt 44 der Sensorebene 42 angeordnet, so dass geometrische Mittelpunkte der Brückenschaltungen 34a-c in den geometrischen Mittelpunkt 44 abgebildet werden können. Alternativ ist ebenfalls vorstellbar, dass, etwa basierend auf Fertigungstoleranzen bei einer Herstellung des 3D Magnetfeldsensors 30, die geometrischen Mittelpunkte der Brückenschaltungen 34a-c in einem Referenzbereich um den geometrischen Mittelpunkt 44 liegen können, beispielsweise dem Referenzbereich 12.

Eine Stromrichtung der TMR-Sensorelemente 32a-d, 36a-d und 38a-d kann basierend auf der CPP-Konfiguration in eine Richtung senkrecht zu der Sensorebene 42 verlaufen, beispielsweise in der z-Richtung, wenn die Sensorebene 42 in der x/y-Ebene angeordnet ist. Eine Polarisierung und/oder Kontaktierung der TMR-Sensorelemente 32a-d, 36a-d und 38a-d kann derart erfolgen, dass während eines Betriebes des 3D Magnetfeldsensors 30 ein Strom in einer jeweiligen Stromrichtung durch die TMR-Sensorelemente 32a-d, 34a-d und 38a-d fließt. Die Stromrichtung kann für alle TMR-Sensorelemente 32a-d, 36a-d und 38a-d gleich sein. In anderen Worten kann der Strom in dieselbe Richtung fließen.

Ein durch den Stromfluss induziertes magnetisches oder elektromagnetisches Störfeld kann homogen sein, wenn der Strom der TMR-Elemente 32a-d; 34a-d und 38a-d in die gleiche Richtung fließt. Ein Strombedarf des 3D Magnetfeldsensors kann in einem Bereich von weniger als 20 µA, weniger als 10 µA oder weniger als 100 nA je TMR-Sensorelemente 32a-d, 36a-d und 38a-d liegen, so dass das Störfeld zusätzlich basierend auf der geringen Stromaufnahme geringe Amplituden aufweisen kann. Ein geringes und/oder homogenes Störfeld ermöglicht eine einfache Kompensation des Störfeldes während einer Auswertung oder Vorverarbeitung der Messsignale U_{x,1}, U_{x,1}, U_{y,1}, U_{y,2}, U_{z,1} und/oder U_{z,2}. Das Störfeld kann basierend auf der geringen Stromaufnahme kleiner sein als bei Hall-Sensoren, die beispielsweise eine Stromaufnahme von wenigen oder einigen Milliampere aufweisen. In anderen Worten erlaubt ein niedriger Strom in jedem einzelnen TMR-Sensor in der Sensorzelle ein sehr geringes und dazu homogenes Störfeld. Dieses lässt sich leicht herausrechnen und ermöglicht somit sehr genaue Messungen bei sehr geringen Magnetfeldstärken.

Der geringe Stromverbrauch, der beispielsweise im Vergleich zu Hall-Sensoren um Größenordnungen oder mehrere Größenordnungen verringert sein kann, weist zusätzlich den Vorteil auf, dass verringerte Ströme während eines Betriebes des 3D Magnetfeldsensors zu einer deutlich geringeren Eigenerwärmung desselben, etwa durch ohmsche Verluste, führen können. Eine geringere Eigenerwärmung ermöglicht eine verlängerte Betriebsdauer zwischen zwei Kühlphasen, bis hin zu einem Non-Stop-Betrieb. In anderen Worten ermöglicht eine Minimalstromaufnahme der xMR-Sensorelemente eine längere, gegebenenfalls unbegrenzte Betriebsdauer. In anderen Worten kann die Hall-Sensortechnologie im Vergleich zu xMR-Sensoren während eines Betriebes die Verwendung deutlich höherer Stromstärken erforderlich machen. Insbesondere für akkubetriebene Anwendungen kann eine Verwendung von xMR-Sensorelementen eine Betriebsdauer deutlich verlängern.

Die Brückenschaltungen 34a, 34b und 34c können auf voneinander verschiedenen Sensorebenen angeordnet sein. Eine laterale Ausdehnung entlang der x- und y-Richtung kann dann verringert sein, da anstelle einer geschachtelten Anordnung der drei Brückenschaltungen jeweils nur eine Brückenschaltung je Ebene angeordnet sein kann. Dies ermöglicht eine weitere Reduktion einer Sensoroberfläche parallel zu der Sensorebene.

Die Brückenschaltungen 34a, 34b und 34c sind symmetrisch bezüglich des geometrischen Mittelpunktes 44, bzw. des Referenzbereichs angeordnet. Eine Symmetrie kann beispielsweise durch einen achssymmetrischen Aufbau derart erfolgen, dass jede der Brückenschaltungen 34a-c symmetrisch zu einer Achse entlang der x-Richtung oder der y-Richtung aufgebaut ist, wobei die Achse den geometrischen Mittelpunkt 44 schneidet. Alternativ können die Brückenschaltungen 34a-c und mithin die TMR-Sensorelemente 32a-d, 36a-d und 38a-d punktsymmetrisch bezüglich des geometrischen Mittelpunktes 44 angeordnet sein.

Eine erreichbare Flussdichteauflösung des 3D Sensorelementes kann beispielsweise kleiner sein als 100 µT, kleiner als 100 nT oder kleiner als 1 nT, beispielsweise 0,1 nT, sein. Dies kann einer Winkelauflösung, etwa bei Verwendung AMR-Sensorelementen, von beispielsweise 0,1° entsprechen.

In anderen Worten können die mehrachsigen Sensoren symmetrische, um eine gemeinsame Flächennormale angeordnete Wheätstone-Brücken mit paarweise jeweils unterschiedlicher magnetischer sensitiver Raumrichtung aufweisen. Die Sensitivitätsachsen, das heißt die zu erfassenden Raumrichtungen, können senkrecht zueinander im Raum angeordnet sein. Um eine möglichst hohe Ortsauflösung zu erreichen, können die drei unterschiedlichen Wheatstone-Brücken in drei Ebenen vertikal, ggf. entlang der Flächennormalen übereinander angeordnet, das heißt gestapelt sein. Die unterschiedlichen Ebenen können als Achsenebenen bezeichnet werden. Alternativ ist auch eine in derselben Ebene liegende, sogenannte äquiplanare, Anordnung, wie sie beispielsweise in den Figuren 1 und 2 gezeigt ist, vorstellbar. Alternativ kann eine Anordnung der Brückenschaltungen auch in zwei Ebenen erfolgen, so dass zwei Wheatstone-Brücken in einer Ebene und die dritte Wheatstone-Brücke in einer zweiten Ebene angeordnet sind.

Bei einer bevorzugten Ausnutzung des GMR- oder TMR-Effektes in Form eines sogenannten Spin-Ventils (engl.: Spin Valve) bzw. MTJ (engl.: Magnetic Tunnel Junction = Magnetischer Tunnelkontakt) kann jede der genannten Wheatstone-Brücken aus vier magnetoresistiven Einzelwiderständen bestehen. Jeweils zwei über eine Leiterbahn direkt miteinander verbundene Einzelwiderstände können dabei eine entgegengesetzte magnetische Anisotropie aufweisen. Diese Anisotropie kann beispielsweise während eines Herstellungsprozesses durch gezielte lokale Heizung über die Néel-Temperatur antiferromagnetischer Bestandteile in den magnetoresistiven Widerständen hinaus einstellbar sein. Dies kann beispielsweise mittels Läserbestrahlung und Abkühlung in einem entsprechenden äußeren Magnetfeld ausreichender Stärke und Orientierung erreicht werden. Bei einer gestapelten Anordnung der Wheatstone-Brücken kann die Heizung beispielsweise derart erfolgen, dass jeweils eine Achsenebene separat erhitzt wird. Weitere Prozessierungsschritte, das heißt Schritte nach der lokalen Einstellung der magnetischen Anisotropie, können bei Temperaturen unterhalb der niedrigsten relevanten Néel-Temperatur erfolgen.

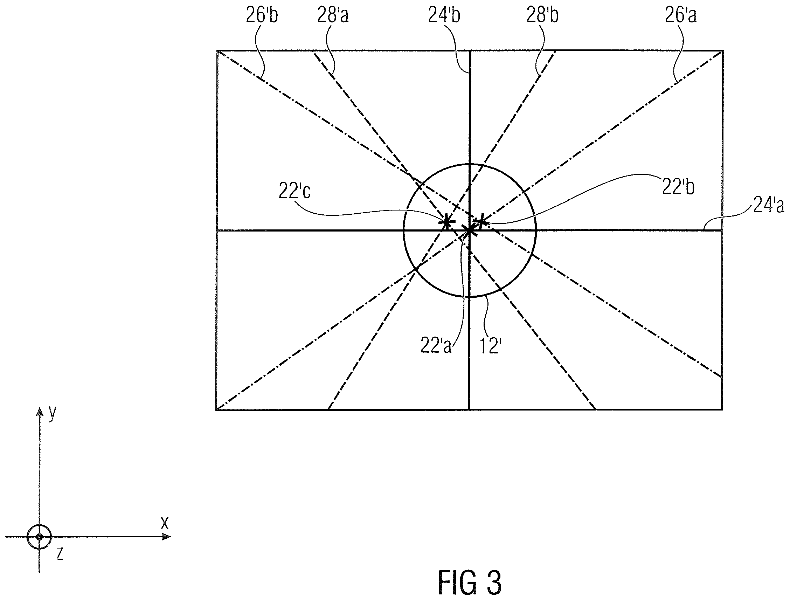

Fig. 3 zeigt eine schematische graphische Darstellung dreier geometrischer Mittelpunkte 22'a-c, die gegenüber den geometrischen Mittelpunkten 22'a-c aus Fig. 2a einen lateralen Versatz entlang der x-, und y-Richtung aufweisen. Ein jeweiliger lateraler Versatz entlang der x-Richtung und/oder y-Richtung kann beispielsweise basierend auf Fertigungstoleranzen während eines Herstellungsprozesses eines 3D Magnetfeldsensors resultieren. Die drei geometrischen Mittelpunkte 22'a-c sind innerhalb eines Referenzbereichs 12' angeordnet, der beispielsweise der Referenzbereich 12 aus Fig. 2a sein kann.

Die jeweilige Brückenschaltung eines 3D Magnetfeldsensors ist ausgebildet, Veränderungen in ohmschen Widerstandswerten der jeweiligen xMR-Sensorelemente in einem variierenden Ausgangssignal bereitzustellen. Die vier xMR-Sensorelemente weisen einen räumlichen Abstand in der x-Richtung, der y-Richtung und/oder der z-Richtung auf. Das bedeutet, dass ein veränderlicher Signalwert eine Widerstandsänderung in einem Bereich, der von der jeweiligen Brückenschaltung umschlossen ist, anzeigt. Die Widerstandsänderung, die eine jeweilige Raumrichtungskomponente des Magnetfeldes anzeigt, kann, etwa als vereinfachende Annahme, als konstant innerhalb des Referenzbereichs 12' angenommen werden, auch wenn die xMR-Sensorelemente der jeweiligen Brückenschaltung gegebenenfalls außerhalb des Referenzbereichs 12' angeordnet sind.

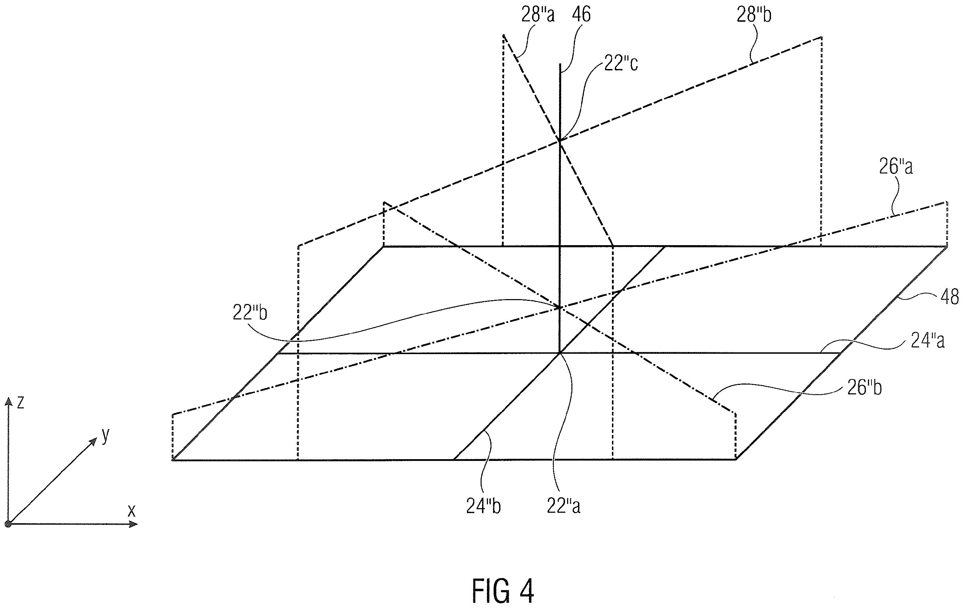

Fig. 4 zeigt eine schematische Darstellung von geometrischen Mittelpunkten 22"a-c, die in verschiedenen Ebenen entlang einer Achse 46 angeordnet sind. Die Achse 46 verläuft parallel entlang der z-Richtung senkrecht zu der x- und y-Richtung. Eine Ebene 48, in der beispielsweise der geometrische Mittelpunkt 22"a einer ersten Brückenschaltung eines 3D Magnetfeldsensors angeordnet ist, kann parallel zur x/y-Ebene angeordnet sein. Die Ebene 48 kann beispielsweise eine Sensorebene, wie etwa die Sensorebene 24 oder 42 sein. Alternativ oder zusätzlich kann die Ebene 48 auch eine Bildebene sein. Eine Bildebene kann beispielsweise die Ebene sein, für welche die Magnetfeldkomponenten erfasst und/oder errechnet werden. Die geometrischen Mittelpunkte 22"a-c sind, entlang der Achse 46 in die Ebene 48 projiziert, deckungsgleich.

Alternativ können die geometrischen Mittelpunkte 22"a-c auch einen Abstand zu der Achse 46 aufweisen. Weisen die geometrischen Mittelpunkte 22"a-c den Abstand auf, so sind die geometrischen Mittelpunkte 22"a-c, wenn sie entlang der Achse 46 in die Ebene 48 projiziert werden, innerhalb des Präferenzbereichs angeordnet. Alternativ oder zusätzlich kann die Ebene 48 auch gekrümmt sein, bspw. wenn ein Substrat, an dem die Brückenschaltungen angeordnet sind, gekrümmt ist.

Anders formuliert zeigt die schematische Darstellung in Fig. 4 eine Anordnung der geometrischen Mittelpunkte 22"a-c, wenn die drei Brückenschaltungen in unterschiedlichen Ebenen, beispielsweise Substratschichten oder Sensorebenen, angeordnet sind. Dies kann beispielsweise daraus resultieren, dass eine jeweilige Brückenschaltung in getrennten Substraten ausgebildet ist und die getrennten Substrate anschließend miteinander verbunden oder gekoppelt werden.

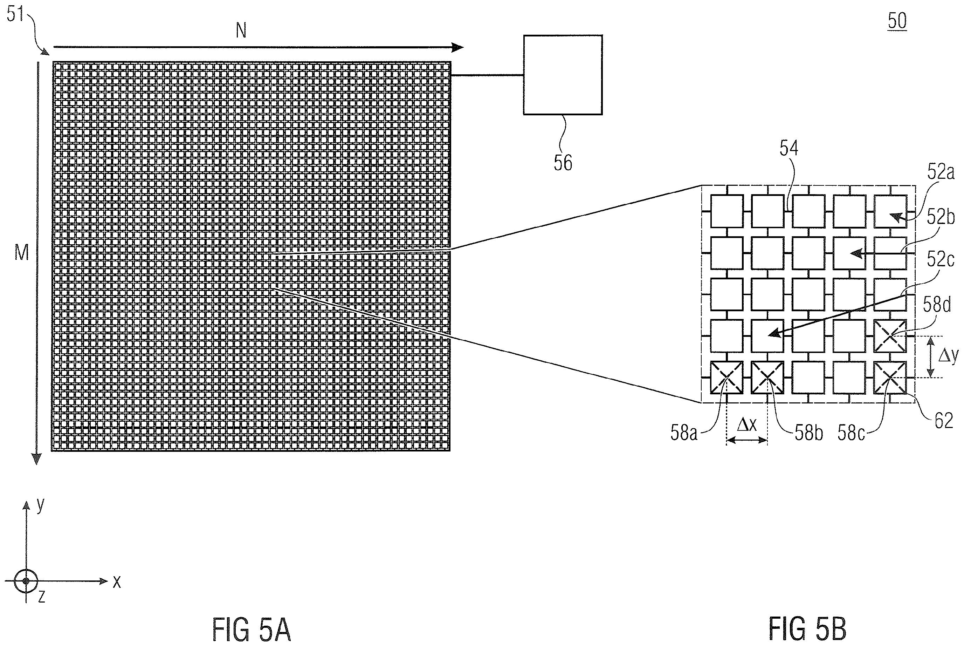

Fig. 5a zeigt eine schematische Aufsicht auf ein 3D Magnetfeldsensorsystem 50, das eine Anzahl von MxN 3D Magnetfeldsensoren in einem MxN Sensorarray 51 aufweist, die in einer Matrix mit M Zeilen und N Spalten angeordnet sind.

Fig. 5b zeigt eine vergrößerte Ansicht eines Teilbereichs des Sensorarrays 51. Der Teilbereich zeigt eine Vielzahl von 3D Magnetfeldsensoren 52a-c, die über eine Auswerteschaltung 54 mit jeweils in x- und/oder y-Richtung benachbarten 3D Magnetfeldsensoren gekoppelt sind.

Die Auswerteschaltung 54 ist ausgebildet, um Signale der 3D Magnetfeldsensoren 52a-c bzw. der Brückenschaltungen, die Informationen bezüglich der erfassten räumlichen Magnetfeldkomponenten Bₓ, B_{y} und B_{z} aufweisen, zu empfangen und beispielsweise einer Verarbeitungseinrichtung 56 bereitzustellen.

Die Verarbeitungseinrichtung 56 kann beispielsweise ein Computer, ein feldprogrammierbares Gatterarray (engl.: Field Programmable Gate Array, FPGA), ein Mikrocontroller oder eine andere Vorrichtung sein, die ausgebildet ist, um die elektrischen Signale der 3D Magnetfeldsensoren 52a-c zu verarbeiten. Beispielsweise kann basierend auf den Signalen der Vielzahl von 3D Magnetfeldsensoren 52a-c eine Auswertung des erfassten Magnetfeldes über ein Sichtfeld, welches von den MxN 3D Magnetfeldsensoren 52a-c erfasst wird, bereitgestellt werden. Die Auswertung kann beispielsweise graphisch erfolgen.

Die 3D Magnetfeldsensoren 52a-c weisen einen Abstand von Δx in der x-Richtung bzw. von Δy in der y-Richtung zu lateral benachbarten 3D Magnetfeldsensoren 52a-c auf. Der Abstand Δx kann beispielsweise durch einen Abstand zweier geometrischer Mittelpunkte 58a und 58b bestimmt sein. Die geometrischen Mittelpunkte 58a und 58b können beispielsweise geometrischen Mittelpunkten zumindest je einer der Brückenschaltungen der 3D Magnetfeldsensoren 52a-c entsprechen. Der Abstand Δy kann beispielsweise eine Entfernung zwischen zwei geometrischen Mittelpunkten 58c und 58d in der y-Richtung sein. Alternativ können die Abstände auch zwischen anderen Punkten oder Kanten der jeweiligen 3D Magnetfeldsensoren 52a-c bestimmt werden. Die Vielzahl von NxM 3D Magnetfeldsensoren ist auf einem Substrat 62 angeordnet. Die Abstände Δx und Δy können gleich sein und beispielsweise Werte von weniger als 50 µm, weniger als 35 µm oder weniger als 15 µm in der x/y-Ebene aufweisen. Alternativ kann das MxN Sensorarray 51 in einer anderen Ebene angeordnet sein, so dass sich die Abstände Δx und Δy auf diese andere Ebene beziehen.

Die Vielzahl von MxN 3D Magnetfeldsensoren bildet mit dem Substrat 62 das MxN Sensorarray 51. Das MxN Sensorarray 51 kann zumindest teilweise aus 3D Magnetfeldsensoren 20 und/oder 3D Magnetfeldsensoren 30 und/oder anderen 3D Magnetfeldsensoren gebildet sein.

In anderen Worten ist die Verarbeitungseinrichtung 56 ausgebildet, um elektrische Signale von den Brückenschaltungen des Sensorarrays zu empfangen und, um basierend auf den elektrischen Signalen eine Information bezüglich der Magnetfeldorientierung in den drei Raumachsen für jeden der MxN 3D Magnetfeldsensoren 52a-c bereitzustellen.

Weisen die Vielzahl von 3D Magnetfeldsensoren 52a-c beispielsweise eine Abmessung von in etwa oder weniger als 10 µm in der x-Richtung und der y-Richtung auf, so kann auch der Abstand Δx und/oder der Abstand Δy in etwa 10 µm betragen. Dies ermöglicht Packungsdichten von 3D Magnetfeldsensoren 52a-c von beispielsweise 1 pro 100 µm², die gegenüber einer beispielsweisen Packungsdichte von 1 pro 10.000 µm², wie sie bei einem Hall-Sensor mit einer Abmessung von in etwa 100 µm in der x-Richtung und der y-Richtung üblich sind, erhöht ist. Die erhöhte Packungsdichte ermöglicht eine erhöhte Auflösung bezüglich des zu erfassenden Magnetfeldes. Das MxN Sensorarray 51 kann als ultrahochauflösend bezeichnet werden.

Jeder der Vielzahl von 3D Magnetfeldsensoren MxN 52a-c kann beispielsweise als ein Punkt oder ein Bereich innerhalb eines basierend auf den Informationen bereitgestellten Bildes des erfassten Magnetfeldes dargestellt werden. Somit kann jede der Sensorzellen 52a-c als Bildelement (engl.: Picture Element, Pixel) bezeichnet werden.

In anderen Worten sind aufgrund des gegenüber Hall-Sensoren erzielbaren höheren Miniaturisierungsgrades von magnetoresistiven Sensoren räumliche Auflösungen von bis zu in etwa 10 µm erreichbar. Eine zeitliche Auflösung des 3D Magnetfeldsensorsystems kann gegenüber der bei Hall-Sensoren erreichbaren Auslesezeiten verringert sein und beispielsweise weniger als 10 µs, weniger als 100 ns oder weniger als 10 ns, gegebenenfalls etwa 1 ns betragen. Eine Zeitauflösung kann dabei von einer Erfassungsrate der Verarbeitungseinrichtung 56 abhängen.

Alternativ können die 3D Magnetfeldsensorelemente 51a-c auch andere Anordnungen aufweisen, beispielsweise können die Zeilen und/oder Spalten der Matrix MxN einen Versatz zueinander aufweisen und/oder diagonal angeordnet sein. Dies kann zu einer Reduzierung von Abbildungsfehlern führen.

Die 3D Magnetfeldsensoren der Sensorschicht können monolithisch beispielsweise durch eine mehrstufige Abfolge eines Abscheidungsschrittes, eines Lithographieschrittes in Kombination mit einem Strukturierungsschritt sowie eines Durchkontaktierungsschrittes bereitgestellt werden.

Alternativ oder zusätzlich ist vorstellbar, dass eine Anzeigeeinrichtung, beispielsweise ein Monitor, ein Display und/oder ein Drucker mit dem Magnetfeldsensorsystem 50 bzw. mit der Verarbeitungseinrichtung 56 gekoppelt ist. Die Anzeigeeinrichtung kann ausgebildet sein, um von der Verarbeitungseinrichtung 56 bereitgestellte Informationen bezüglich der Magnetfeldorientierung in den drei Raumachsen für eine Vielzahl oder für jeden der MxN 3D Magnetfeldsensoren bzw. die Orientierung basierend auf der Information darzustellen. Ist die Anzeigeeinrichtung beispielsweise ein Drucker, so kann die Darstellung der Information beispielsweise eine Darstellung von Magnetfeldlinien des Magnetfeldes zu einem Zeitpunkt umfassen. Ist die Anzeigeeinrichtung beispielsweise ein Display, so können ebenfalls Magnetfeldlinien dargestellt werden. Alternativ können auch Magnetfeldverläufe oder Magnetfeldstärken darstellbar sein. Mittels eines Displays kann eine Abfolge solcher Darstellungen, etwa in Form einer Bildfolge oder eines Films bereitstellbar sein. Insbesondere kann solch ein Magnetfeldkamerasystem als portables Gerät ausführbar sein.

In anderen Worten kann eine derartige Vorrichtung eine handliche Anordnung für elektronische Magnetfeldanalysen, das heißt eine Magnetfeldkamera, sein. Alternativ oder zusätzlich kann das Magnetfeldkamerasystem beispielsweise eine sogenannte EMV-Brille (EMV = elektromagnetische Verträglichkeit) und bspw. ein Analysegerät für eine Prüfung oder Beurteilung die elektromagnetische Verträglichkeit von Komponenten sein. Beispielsweise kann mittels einer EMV-Brille eine Quelle elektromagnetischer Störstrahlung auf einer Platine darstellbar sein.

Ferner ist ein Einsatz in Bereichen der Materialprüfung und -entwicklung denkbar, etwa zur Feststellung bzw. Überprüfung des magnetischen Feldes von Permanentmagneten nach deren Fertigung oder zur Feststellung von Materialfehlern und/oder -inhomogenitäten oder dergleichen.

Ferner ist ein Einsatz zur Warenprüfung, etwa zur sicheren Erkennung und Unterscheidung von magnetisch signierten Objekten bzw. Stoffen bei Durchgangsprüfungen durch räumliche Erfassung eines von ihnen ausgehenden bzw. durch sie magnetisierten Magnetfeldes, und/oder ein erweiterter produkt- und anwendungsspezifischer Diebstahlschutz vorstellbar.

Eine Magnetfeldkamera ist ferner zur Messung und/oder Bestimmung elektromagnetischer Verträglichkeit, etwa mit einer räumlich präzisen Erfassung der zeitlich hochfrequent veränderlichen Magnetfelder von elektronischen Bauteilen oder durch eine Messung von Gradienten in Magnetfeldern von elektrischen Anlagen, wie etwa in der Stromnetztechnik, vorstellbar.

Eine derartige Magnetfeldkamera könnte ferner in der medizinischen Bildgebung und Diagnostik einsetzbar sein, etwa zur dreidimensionalen Verfolgung von magnetisch markierten Objekten bzw. Stoffen in einem Organismus (in vivo), gegebenenfalls in Echtzeit, oder zur Erfassung des magnetischen Feldes von Organismen, etwa zum Ziehen von Rückschlüssen auf Nervenströme, Gehirnaktivitäten oder dergleichen.

Ferner könnte eine derartige Magnetfeldkamera als ein Gerät zur Bildgebung, etwa in medizinischer, chemischer, biochemischer und/oder biophysikalischer Grundlagenforschung oder in der Neurologie einsetzbar sein und eine Unterscheidung und/oder eine dreidimensionale, zeitlich hochaufgelöste Verfolgung von magnetisch markierten bzw. intrinsisch magnetischen Objekten ermöglichen. Magnetische Objekte können bspw. magnetisch markierbare Molekülen und/oder Kolloide sein.

Dies kann anhand einer magnetischen Signatur der Objekte ermöglicht werden, etwa als Erweiterung in optischen Mikroskopieanordnungen. Alternativ kann eine Magnetfeldkamera zur in vitro-Analyse von chemischen Reaktionen bzw. biochemischen Prozessen durch Ausnutzung einer magnetischen Markierung und deren Erfassung, gegebenenfalls in Echtzeit, dienen.

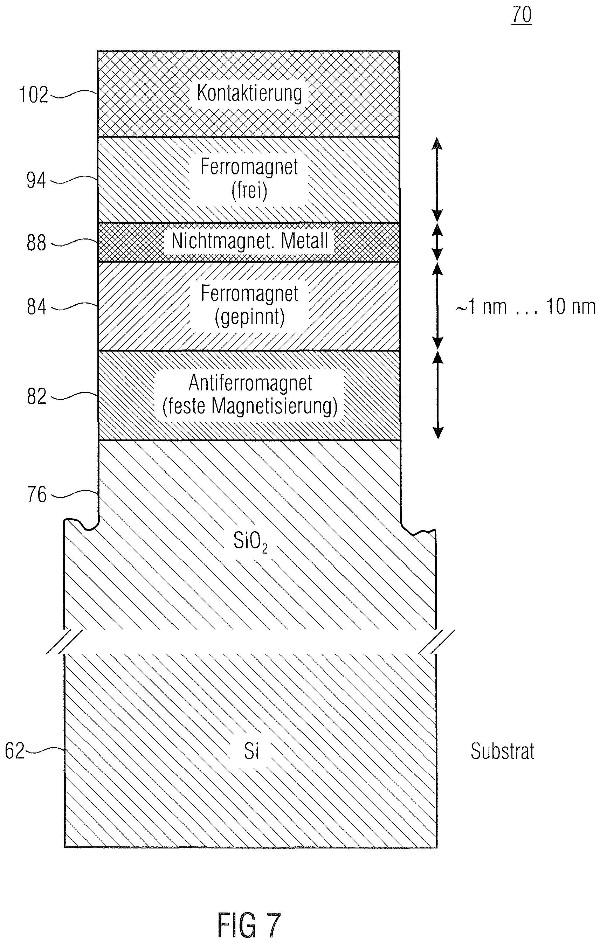

Beispielsweise kann eine derartige Magnetfeldkamera mit dreiachsigen GMR-Spin-Ventil-Sensoren mit Schichtstapeln aufweisen, wie sie beispielsweise in Fig. 7 dargestellt sind, wenn die 3D Magnetfeldsensoren auf dem GMR-Effekt basieren. Eine Differenzierung der raumrichtungsabhängigen Sensitivitäten der einzelnen Brückenwiderstände, das heißt der Sensorelemente der Brückenschaltungen, kann durch eine unterschiedliche Magnetisierung des Antiferromagneten, etwa mittels planarer oder vertikaler Anisotropie erfolgen.

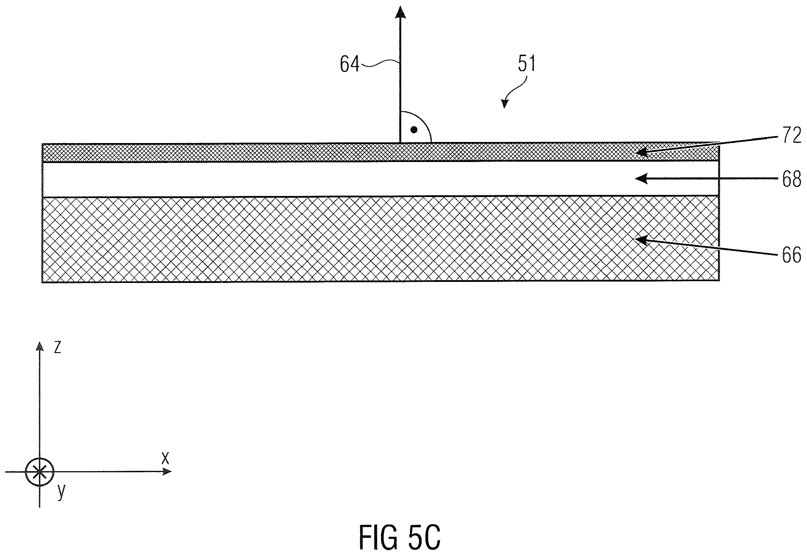

Fig. 5c zeigt eine schematische Seitenschnittansicht eines Ausschnitts des Sensorarrays 51. Eine Richtung der Seitenschnittansicht ist gegenüber der Aufsichten in Fig. 5a und 5b um 90° im Raum gedreht, so dass die y-Richtung in die Zeichnungsebene (x/z-Ebene) hinein weist, wie es durch das umrandete x im Schnittpunkt von x-Achse und z-Achse angedeutet ist. Abmessungen, insbesondere entlang einer Richtung 64, die beispielsweise senkrecht auf einer Oberfläche des Sensorarrays 51 und/oder parallel zu der z-Richtung verläuft, sind stark vergrößert dargestellt. Das Sensorarray 51 weist eine Steuerschicht 66 auf. Die Steuerschicht 66 kann beispielsweise eine runde, polygone oder eckige Plattenstruktur mit zwei gegenüberliegenden Hauptseitenbereichen sein.

Die Steuerschicht kann Leiterbahnen, Widerstände und logische Bauelemente, wie etwa Transistoren, aufweisen. Die Widerstände und logischen Bauelemente können so angeordnet werden, dass einerseits eine niederohmige (Konstant-)Strom- bzw. Spannungsversorgung einer kontaktierten Sensorschicht, etwa mittels der Spannung U₀ in Fig. 2a oder Fig. 2b, ermöglicht ist und andererseits eine Adressierung und Auslesung von differentiellen Brückenspannungen, etwa, *U*_{*xᵢ*,2} *- U*_{*xᵢ*,1}, *i* ∈ {1,2,3} jeder einzelnen Wheatstone-Brücke in der Sensorschicht, sowohl in gestapelter als auch in äquiplanarer Ausführung, ermöglicht ist.

An einem Hauptseitenbereich der Steuerschicht 66 ist eine Durchkontaktierungsschicht 68 angeordnet. Die Durchkontaktierungsschicht 68 weist ebenfalls zwei Hauptflächenbereiche auf, wobei einer der Hauptflächenbereiche einem Hauptflächenbereich der Steuerschicht 66 zugewandt angeordnet ist. An einem gegenüberliegenden und von der Steuerschicht 66 abgewandten Oberflächenbereich ist eine Sensorschicht 72 in einer oder mehreren Ebenen angeordnet. Die 3D Magnetfeldsensoren des Sensorarrays 51 sind in der Sensorschicht 72 angeordnet. Die Auswerteschaltung kann beispielsweise in der Steuerschicht 66 integriert sein. Die Steuerschicht 66 kann mittels der Durchkontaktierungsschicht 68 mit der Sensorschicht 72 bzw. den 3D Sensorelementen verbunden sein.

Die Durchkontaktierungsschicht 68 kann somit als eine Verbindungsstruktur zwischen der Sensorschicht 72 und der Steuerschicht 66, insbesondere wenn diese die Auswerteschaltung aufweist, beschrieben werden.

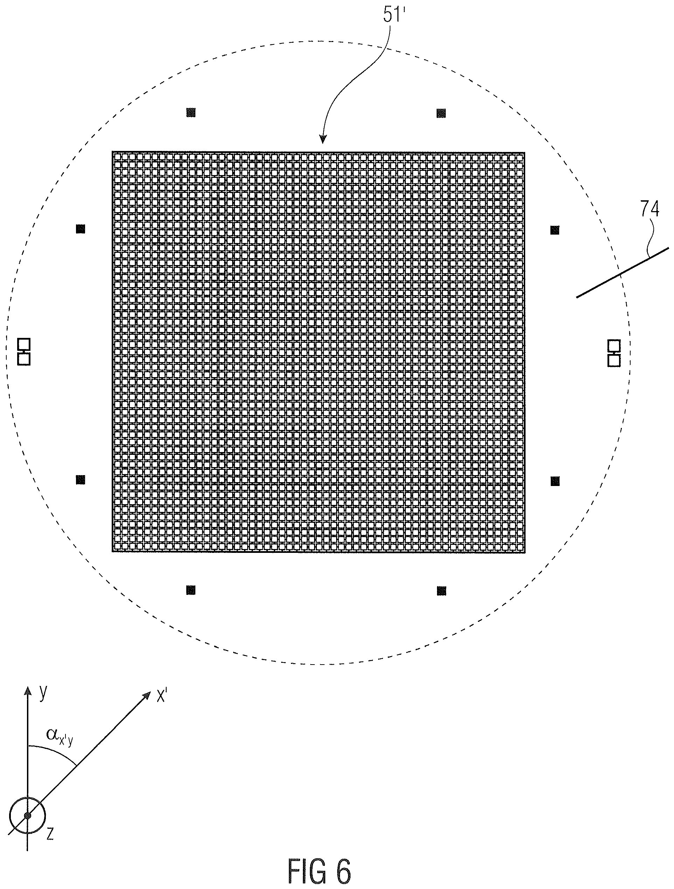

Fig. 6 zeigt eine schematische Aufsicht auf einen Wafer 74 mit einem MxN Sensorarray 51'. Der Wafer 74 kann das Sensorarray 51' beispielsweise während eines Herstellungsprozesses des 3D Magnetfeldsensorsystems 50 oder des Sensorarrays 51 aufweisen.

Weist der Wafer 74 beispielsweise einen Durchmesser von 100 mm auf, kann das Sensorarray 51' beispielsweise eine Abmessung in der y-Richtung von 60 mm aufweisen. In einer Richtung x', die einen Winkel α_{x'y} von in etwa 45° und mithin ungleich 90° zu der y-Richtung aufweist, kann das Sensorarray 51' beispielsweise eine Abmessung von ca. 85 mm aufweisen.

Solange die Raumrichtungen x, y und z entlang linear unabhängiger Ortsvektoren im Raum verlaufen, ist es gegenüber einem kartesischen Koordinatensystem bspw. möglich, dass die Achsen x, y und/oder z auch einen anderen, (zu 90°) unterschiedlichen Winkel zueinander aufweisen, d. h., die drei Raumrichtungen können auch einen Winkel von ungleich 90° und ungleich 0° zueinander aufweisen.

Weist der Wafer alternativ beispielsweise einen Durchmesser von 300 mm auf, kann eine Abmessung des Sensorarrays 51' in der y-Richtung und in einer Richtung senkrecht zu der y-Richtung beispielsweise 180 mm betragen. In der Richtung x', beispielsweise entlang einer Diagonalen des Sensorarrays 51' kann das Sensorarray 51' eine Abmessung von in etwa 255 mm aufweisen.

Ein Substrat des Sensorarrays 51' und mithin des Sensorarrays 51 kann basierend auf einer Herstellung auf Wafer-Level einstückig, das heißt monolithisch, gebildet sein, wenn das Sensorarray 51' auf einem einstückigen Wafer 74 gebildet ist.

In anderen Worten kann eine Sensorschicht, beispielsweise die Sensorschicht 72 des Sensorarrays 51 in Fig. 5b monolithisch bereitgestellt werden. Der Wafer 74 kann beispielsweise eine auf eine jeweilige Sensorschicht, beispielsweise gebildet durch die MxN 3D Magnetfeldsensoren, angepasste, das heißt maßgeschneiderte, Auswerteschaltung, etwa eine anwendungsspezifische integrierte Schaltung (engl.: Application-Specific Integrated Circuit, ASIC), etwa auf CMOS-Basis, als sogenannte Steuerschicht aufweisen. Alternativ können die Sensorschicht auf einem ersten Wafer und die Auswerteschaltung auf einem zweiten Wafer gebildet sein und der erste und der zweite Wafer passgenau mittels eines Bondingverfahrens verbunden werden. In anderen Worten kann die fertig prozessierte Sensorschicht auf einem separaten Wafer durch eine geeignete Bonding-Technik passgenau auf einem weiteren, die Steuerschicht enthaltenen Wafer, aufgebracht und verbunden werden.

Beispielsweise kann ein 3D Magnetfeldsensor, etwa der 3D Magnetfeldsensor 20 oder 30, oder ein Sensorarray wie nachfolgend erläutert, herstellbar sein. Nachfolgende Erläuterungen zeigen eine äquiplanare Anordnung zweier Brückenschaltungen in einer Ebene und eine gestapelte Anordnung der dritten Brückenschaltung. Dies kann als eine Hybridform zwischen äquiplanarer und gestapelter Anordnung bezeichnet werden. Die in den Figuren 1 und 2 als innen liegend dargestelltem Wheatstone-Brücken, etwa die Brückenschaltungen 32a und 32b in Fig. 2b, sind in derselben Ebene, das bedeutet äquiplanar angeordnet und ausgebildet, um mit einer planaren, (in-plane-) Sensitivität eine Erfassung der Magnetfeldkomponenten Bₓ, B_{y} in einer x- und y-Richtung zu ermöglichen.

Die äußere Wheatstone-Brücke ist in einer zu jener x-y-Ebene parallel und vertikal in z-Richtung verschobenen Ebene angeordnet und ist ausgebildet, um eine Signalerfassung einer Komponente B_{z} in der z-Ebene zu ermöglichen. Dies kann mittels einer vertikalen, das heißt out-of-plane-Sensitivität, erfolgen und mittels einer Austauschwechselwirkung, rechtwinklig zur Oberfläche PEB (PEB = Perpendicular Exchange Bias) realisiert sein.

Mithin können sowohl statische als auch zeitlich veränderliche Magnetfelder mit mikroskopischer Ortsauflösung und hoher Zeitauflösung in Betrag und Richtung elektronisch erfasst werden. Eine monolithische Herstellung, beispielsweise mittels Komplettwafern ermöglicht ein großes Sichtfeld von zumindest 60 mm x 60 mm. Alternativ oder zusätzlich kann das Sichtfeld auch durch eine Kopplung mehrerer Sensorarrays vergrößert werden.

Für einen der genannten zwei möglichen Fälle, bei dem die z-Ebene vom Wafer ausgesehen über der x-y-Ebene liegt, das heißt eine größere Entfernung zu dem Substrat aufweist, als die Sensorelemente in der x-y-Ebene, kann der Fabrikationsprozess auf Wafer-Level folgende Schritte aufweisen. Ferner können die Steuerschicht und die Sensorschicht beispielsweise auf unterschiedlichen Wafern hergestellt werden, so dass diese nach ihrer jeweiligen Fertigung passgenau gebondet werden können. Alternativ können die Steuerschicht und die Sensorschicht auch auf demselben Wafer gefertigt werden.

Ein Ausgangszustand des Wafers der Sensorschicht, beispielsweise der Wafer 74, kann durch einen handelsüblichen Wafer gegeben sein, etwa aus Silizium gebildet und etwa einen Durchmesser zwischen vier Zoll und acht Zoll aufweisen. Der Wafer kann beispielsweise eine Dicke von ca. 0,5 mm aufweisen. Alternativ kann der Wafer auch eine beliebige andere Abmessung aufweisen. Die Prozessierung umfasst die folgenden Arbeitsschritte für die x-y-Ebene:
Ein erster Schritt umfasst eine Waferreinigung mit anschließender thermischer Oxidation oder einer SiO₂-Abscheidung (z.B. thermisch mit einer Oxiddicke in einem Bereich zwischen 50 nm und 800 nm, 100 nm und 500 nm oder 150 nm und 300 nm mit anschließendem Tempern bei einer Temperatur in einem Bereich zwischen 400°C und 1200 °C, 500°C und 1000°C oder 600°C und 800°C über eine Dauer in einem Bereich von 10 min und 300 min, 15 min und 150 min oder 20 min und 60 min oder über chemische Gasphasenabscheidung.

Ein optionaler zweiter Schritt umfasst ein Setzen von Prozessmarken mittels Lithografie und geeignete Ätz- sowie Reinigungsverfahren bspw. unter Verwendung eines Fotolacks und einer geeigneten Maske, eine anschließende Belichtung und reaktives lonenätzen bis zu einer Tiefe von in einem Bereich zwischen 10 nm und 500 nm, 30 nm und 400 nm oder 50 nm und 200 nm sowie eine anschließend Plasmalackentfernung und/oder zusätzliche nasschemische Reinigung.

Ein dritter Schritt umfasst eine hochhomogene Abscheidung und Strukturierung eines geeigneten GMR-Schichtstapels mit erzielbarer planarer magnetischer Anisotropie über die gesamte Waferoberfläche mittels physikalischer oder chemische Gasphasenabscheidung (ggf. unter Verwendung einer zusätzlichen Tantal-Keimschicht mit einer geeigneten Dicke in einem Bereich zwischen 1 nm und 10 nm, 2 nm und 8 nm oder 3 nm und 5 nm zur Verbesserung der Haftung der folgenden GMR-Schichten.

Ein vierter Schritt umfasst eine Abscheidung einer Tantal-Hartmaske über physikalische oder chemische Gasphasenabscheidung mit einer Dicke, die in etwa derjenigen des GMR-Schichtstapels entspricht.

Ein fünfter Schritt umfasst eine Strukturierung des GMR-Stapels in gewünschter Form, z. B. als separierte Mäander für zwei x-y-Wheatstone-Brücken je Sensor entsprechend Fig. 2a. Entsprechende Verfahren für TMR-Schichten bzw. TMR-Schichtstapel gestalten sich ähnlich, bis auf (ggf. gering) modifizierte Kontaktierungen infolge der "current-out-of-plane"- bzw. CPP-Stromführung. Die Strukturierung von GMR-Schichtstapeln kann sich beispielsweise in die folgenden Teilschritte untergliedern:
a. Lithografie mit geeigneter Maske (Fotolack z. B. OiR 906-17 mit bspw. 1, 2 oder 3 µm Dicke)
b. Trockenätzen der Tantal-Hartmaske (z.B. über Argon-Sputtern bei einer Leistung in einem Bereich von bspw. 5-50 W, 10-40 W oder 15-30 W und unter einer Schutzatmosphäre, etwa aus Schwefelhexafluorid). Dieser Schritt umfasst bspw. eine flächige Entfernung der Tantal-Hartmaske "bis auf das Oxid", das in Schritt 1 angeordnet wird.
c. Lackentfernung (z.B. Nasslackentfernung mittels Aceton, lisoPUR© o.ä. in einem Bad mit geeigneter Temperatur, etwa in einem Bereich zwischen 40°C und 100°C, 45°C und 80°C oder 50°C und 70°C und ggf. Ultraschallbehandlung mit einer Frequenz von mehr als 26 kHz, 30 kHz oder 34 kHz.
d. Trockenätzen des GMR-Stapels (z.B. mittels Argon-Sputtern analog zu Punkt b, gezielte künstliche Prozesspausen für mehrfache Wiederabkühlung).

Ein sechster Schritt umfasst eine Passivierung der Waferoberfläche über chemische oder physikalische Gasphasenabscheidung, beispielsweise mit Siliziumoxid (z.B. über plasmagestützte chemische Gasphasenabscheidung in einem Temperaturbereich zwischen 150°C und 300°C, 160°C und 250°C oder 170°C und 190°C mit einer Dicke in einem Beriech zwischen von 100 nm und 800 nm, 200 nm und 600 nm oder 250 nm und 500 nm. Diese Dicke kann so gewählt werden, dass im Falle einer lasergestützten späteren Setzung der magnetischen Anisotropie eine Entstehung unerwünschter Interferenzeffekte an der Passivierungsschicht verringert oder verhindert ist.

Ein siebter Schritt umfasst ein Hinzufügen von metallischen Leitbahnen zur Kontaktierung der GMR-Mäander (z.B. in Damascene-Technologie) bspw. mittels der folgenden Teilschritte:
a. Strukturierung der Passivierungsschicht entsprechend der erforderlichen metallischen Leitbahnen (z.B. mittels Fotolack OiR 906-17 und einer geeigneten Maske, Trockenätzen bis auf GMR-Stapel, Nasslackentfernung wie in Punkt 5.c)
b. Abscheidung von Metall(en) als Haftschicht, ggf. Barriereschicht sowie als Galvanik-Startschicht über physikalische oder chemische Gasphasenabscheidung (z. B. 5 nm, 10 nm oder 15 nm Tantal sowie einer Kupferschicht mit einer Dicke in einem Bereich zwischen 50 nm und 300 nm, 70 nm und 200 nm oder 90 nm und 150 nm)
c. Kupfer-Galvanik (z. B. mit einer Höhe bzw. Schichtdicke in einem Bereich zwischen 1000 nm und 3000 nm, 1200 nm und 2500 nm oder 1400 nm und 2000 nm)
d. chemisch-mechanisches Polieren bis auf Oxid.

Nachfolgend kann die Brückenschaltung für die Erfassung der Magnetfeldkomponenten in der z-Ebene angeordnet werden. Dies kann folgende weitere Schritte umfassen:
Ein achter Schritt umfasst eine homogene Abscheidung eines geeigneten GMR-Schichtstapels mit erzielbarer vertikaler magnetischer Anisotropie über die gesamte Waferoberfläche mittels physikalischer oder chemischer Gasphasenabscheidung, wie es für Schritt drei beschrieben ist.

Ein neunter Schritt kann ähnlich dem vierten Schritt ausführbar sein und eine Abscheidung einer Tantal-Hartmaske über physikalische oder chemische Gasphasenabscheidung mit einer Dicke, die in etwa derjenigen des GMR-Schichtstapels entspricht, umfassen.

Ein zehnter Schritt kann ähnlich dem fünften Schritt ausführbar sein und eine Strukturierung des GMR-Stapels in gewünschter Form umfassen, z.B. als separierte Mäander für zwei x-y-Wheatstone-Brücken je Sensor entsprechend Fig. 2a. Die Strukturierung kann sich beispielsweise in die folgenden Teilschritte untergliedern:
a. Lithografie mit geeigneter Maske (Fotolack z.B. OiR 906-17 mit bspw. 1, 2 oder 3 µm Dicke)
b. Trockenätzen der Tantal-Hartmaske (z.B. über Argon-Sputtern bei einer Leistung in einem Bereich von bspw. 5-50 W, 10-40 W oder 15-30 W und unter einer Schutzatmosphäre, etwa aus Schwefelhexafluorid)
c. Lackentfernung (z.B. Nasslackentfernung mittels Aceton, lisoPUR© o.ä. in einem Bad mit geeigneter Temperatur, etwa in einem Bereich zwischen 40°C und 100°C, 45°C und 80°C oder 50°C und 70°C und ggf. Ultraschallbehandlung mit einer Frequenz von mehr als 26 kHz, 30 kHz oder 34 kHz.
d. Trockenätzen des GMR-Stapels (z.B. mittels Argon-Sputtern analog zu Punkt b, gezielte künstliche Prozesspausen für mehrfache Wiederabkühlung)..

Ein elfter Schritt kann ähnlich dem sechsten Schritt ausführbar sein und eine Passivierung der Waferoberfläche über chemische oder physikalische Gasphasenabscheidung umfassen, beispielsweise mit Siliziumoxid (z. B. über plasmagestützte chemische Gasphasenabscheidung in einem Temperaturbereich zwischen 150°C und 300°C, 160°C und 250°C oder 170°C und 190°C mit einer Dicke in einem Beriech zwischen von 100 nm und 800 nm, 200 nm und 600 nm oder 250 nm und 500 nm. Diese Dicke kann so gewählt werden, dass im Falle einer lasergestützten späteren Setzung der magnetischen Anisotropie eine Entstehung unerwünschter Interferenzeffekte an der Passivierungsschicht verringert oder verhindert ist..

Ein zwölfter Schritt umfasst ein Hinzufügen von metallischen Leitbahnen zur Kontaktierung der GMR-Mäander der z-Ebene sowie eine geeignete Durchkontaktierung zu Leitbahnen der x-y-Ebene (z.B. in Damascene-Technologie), etwa analog zu den Ausführungen in Schritt sieben.

Anschließend kann mittels lokaler Laserheizung und Abkühlung im äußeren Magnetfeld sowohl für die x-y- als auch für die z-Ebene die magnetische Anisotropie sukzessive für jeden 3D Magnetfeldsensor, beispielsweise jedem Mäander, in der jeweils erforderlichen Richtung realisiert werden. Anschließend kann das Bonden des die Sensorschicht umfassenden Wafers mit dem die Steuerschicht umfassenden Wafer erfolgen, wobei die Prozessschritte derart ausführbar sind, dass beispielsweise die beiden Néel-Temperaturen der in den jeweiligen GMR-Stapeln enthaltenden antiferromagnetischen Stoffe unterschritten bleiben.

Wird hingegen ein TMR-Stapel strukturiert, so kann der fünfte Schritt in Teil b so ausgeführt werden, dass eine Entfernung der Tantal-Hartmaske partiell bis zu der Tantal-Keimschicht (vgl. Schritt 3) hin erfolgt, so dass die Tantal-Keimschicht elektrisch kontaktierbar ist, und eine CPP-Konfiguration umsetzbar ist.

Fig. 7 zeigt eine schematische Seitenschriittansicht eines beispielhaften Schichtstapels 70 mit einer planaren magnetischen Anisotropie, wie er bspw. mittels des oben beschriebenen Verfahrens herstellbar ist. Eine Schichtfolge des Schichtstapels 70 kann in etwa die Schichten in folgender Reihenfolge und von dem Substrat 62 ausgehend entsprechen. An dem Substrat 62 kann eine Oxidschicht 76 angeordnet sein, wobei an der Schicht 76 eine antiferromagnetische Schicht 82, eine Schicht 84 umfassend einen gepinnten, d. h., mit einer Vorzugsrichtung versehenen, Ferromagneten, eine Schicht 88 umfassend ein nichtmagentisierbares Metall, eine ferromagnetische Schicht 94 und eine Kontaktierungsschicht 102 angeordnet sind.

In anderen Worten zeigt Fig. 7 ein Beispiel eines Spin-Ventil-Schichtstapels als Grundlage für die beispielhaft in der Fig. 2a dargestellten Mäander.

In anderen Worten lassen sich Magnetfelder durch die Verwendung magnetoresistiver (MR) Sensorelemente in der Sensorebene, das heißt der Sensorschicht, in Verbindung mit einem geeigneten ASIC in Form der Steuerschicht sowohl in höherer räumlicher als auch in höherer zeitlicher Auflösung gegenüber Hall-Sensoren in Betrag und Richtung elektronisch erfassen. So übertrifft das erzielbare räumliche Auflösungsvermögen von deutlich unter 100 µm entscheidend dasjenige von Hall-Sensoren, da die MR-Sensoren einen höheren Miniaturisierungsgrad erlauben. Die erreichbare zeitliche Auflösung ist sogar um viele Größenordnungen derjenigen von Hall-Sensoren überlegen.

Infolgedessen können bei Verwendung eines geeigneten ASIC-Auslesetaktes im Bereich von Nanosekunden, entsprechend Taktraten im GHz-Bereich, erzielt werden. Somit kann sich die präzise Erfassung der zeitlich hochfrequent veränderlichen magnetischen Abstrahlung von elektrischen Geräten und Anlagen, beispielsweise im Kontext von Untersuchungen zur elektromagnetischen Verträglichkeit, oder auch derjenigen von biologischen Systemen, beispielsweise im Rahmen neurowissenschaftlicher Untersuchungen, eignen.

Ferner ist auch eine Sensitivität der eingesetzten MR-Sensoren derjenigen von Hall-Sensoren und somit der darauf basierenden Erfassungssysteme deutlich überlegen. Basierend auf einer hohen Sensitivität der MR-Sensoren können Systeme mit ebenjenen ausgebildet sein, magnetische Felder bzw. Unterschiede in diesen mit einer Auflösung von größenordnungsmäßig einem Mikrotesla (1 µT) bis hin zu 0,1 nT erfassen. Eine lokale mikroskopische Richtung eines Magnetfeldes lässt sich ferner mit einer im Vergleich zu Hall-Sensoren signifikant besseren Auflösung von bis zu 0,1° messen.

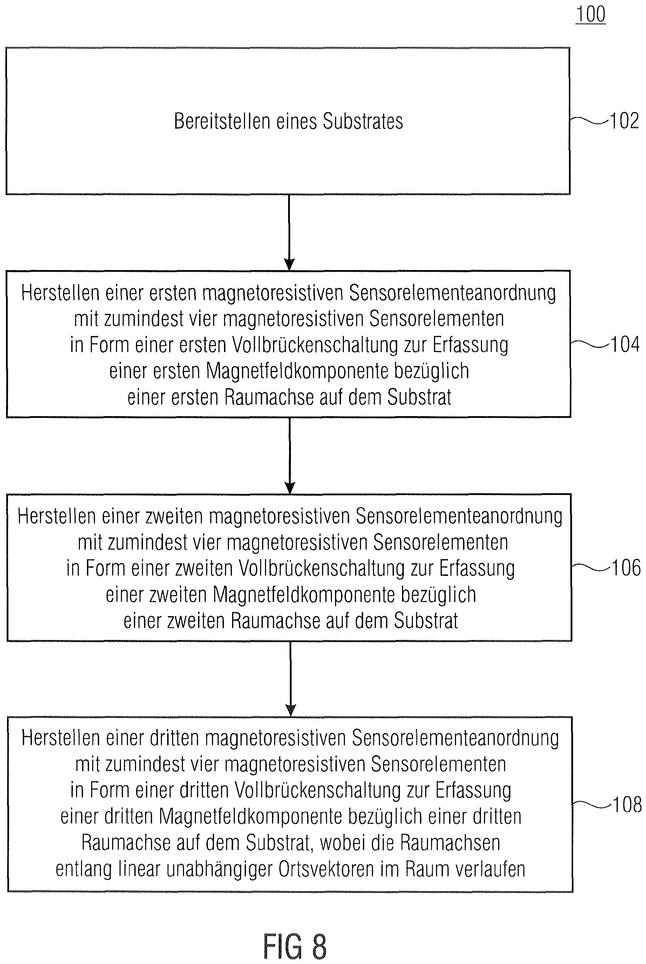

Fig. 8 zeigt ein schematisches Ablaufdiagramm eines Verfahrens 100 zum Herstellen eines 3D Magnetfeldsensors, wie etwa der 3D Magnetfeldsensor 10, 20 oder 30. Ein erster Schritt 102 umfasst ein Bereitstellen eines Substrates.

Ein zweiter Schritt 104 umfasst ein Herstellen einer ersten magnetoresistiven Sensorelementeanordnung mit zumindest vier magnetoresistiven Sensorelementen, etwa der magnetoresistiven Sensorelemente 14a-d aus Fig. 2a, in Form einer ersten Vollbrückenschaltung zur Erfassung einer ersten Magnetfeldkomponente bezüglich einer ersten Raumachse auf dem Substrat;

Ein dritter Schritt 106 umfasst ein Herstellen einer zweiten magnetoresistiven Sensorelementeanordnung mit zumindest vier magnetoresistiven Sensorelementen, etwa der magnetoresistiven Sensorelemente 16a-d aus Fig. 2a, in Form einer zweiten Vollbrückenschaltung zur Erfassung einer zweiten Magnetfeldkomponente bezüglich einer zweiten Raumachse auf dem Substrat.

Ein vierter Schritt 108 umfasst ein Herstellen einer dritten magnetoresistiven Sensorelementeanordnung mit zumindest vier magnetoresistiven Sensorelementen, etwa der magnetoresistiven Sensorelemente 18a-d aus Fig. 2a in Form einer dritten Vollbrückenschaltung zur Erfassung einer dritten Magnetfeldkomponente bezüglich einer dritten Raumachse auf dem Substrat, wobei die drei Raumachsen entlang linear unabhängiger Ortsvektoren im Raum verlaufen.

Obwohl in vorangegangenen Ausführungsbeispielen 3D Magnetfeldsensoren unter Verwendung von GMR-Effekten (3D Magnetfeldsensor 20 in Fig. 2a) bzw. unter Verwendung von TMR-Sensorelementen (3D Magnetfeldsensor 30 in Fig. 2b) beschrieben wurden, können 3D Magnetfeldsensoren auch andere xMR-Sensorelemente, bevorzugt GMR-Sensorelemente, TMR-Sensorelemente oder AMR-Sensorelemente und besonders bevorzugt GMR-Sensorelemente und TMR-Sensorelemente aufweisen.

Obwohl die 3D Magnetfeldsensoren 20 und 30 in Fig. 2a und in Fig. 2b so beschrieben wurden, dass jede der drei Brückenschaltungen jeweils vier identische xMR-Sensorelemente aufweist und die drei Brückenschaltungen ebenfalls verglichen miteinander gleiche Typen von xMR-Elementen aufweisen, ist ebenfalls vorstellbar, dass 3D Magnetfeldsensoren voneinander verschiedene Arten von xMR-Sensorelementen aufweisen, etwa GMR-Sensorelemente zur Erfassung des Magnetfeldes in der x-Richtung und der y-Richtung sowie beispielsweise GMR-Sensorelemente zur Erfassung der z-Richtung. Alternativ oder zusätzlich können auch von einander verschieden Arten von xMR-Sensorelemente in einer Brückenschaltung angeordnet sein.

Obwohl in vorangegangenen Ausführungsbeispielen die Brückenschaltungen stets vier veränderliche Widerstandselemente aufweisen, ist ebenfalls vorstellbar, dass eine Brückenschaltung lediglich zwei veränderliche Widerstandselemente oder ein veränderliches Widerstandselement aufweist. Ferner ist ebenfalls vorstellbar, dass eine, mehrere oder alle Brückenschaltungen vier xMR-Sensorelemente aufweisen, wobei beispielsweise zwei, das heißt je eines in einer Halbbrücke, magnetisch geschirmt angeordnet sind, so dass lediglich zwei, das heißt eines je Halbbrückenschaltung, basierend auf veränderlichen Magnetfeldern veränderliche Widerstandswerte aufweisen, Temperatureffekte jedoch basierend auf einer homogenen Änderung aller vier xMR-Sensorelemente kompensiert werden können.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

### Literatur

[1] EP 1 720 026 B1
[2] EP 1 720 026 A1
[3] US 20070046287 A1
[4] US 7,902,820 B2
[5] EP 2508906 A2
[6] JP 2012185155 A
[7] US 20120209546 A1

## Patentansprüche

1. 3D Magnetfeldsensor (10; 20) zur Erfassung von drei räumlichen Magnetfeldkomponenten (Bₓ; B_{y}; B_{z}) in einem Referenzbereich (12; 44) mit folgenden Merkmalen:
einer ersten magnetoresistiven Sensorelementeanordnung (14a-d) zur Erfassung einer ersten Magnetfeldkomponente (Bₓ) bezüglich einer ersten Raumachse (x) und bezüglich des Referenzbereichs (12; 44);
einer zweiten magnetoresistiven Sensorelementeanordnung (16a-d) zur Erfassung einer zweiten Magnetfeldkomponente (B_{y}) bezüglich einer zweiten Raumachse (y) und bezüglich des Referenzbereichs (12; 44); und
einer dritten magnetoresistiven Sensorelementeanordnung (18a-d) zur Erfassung einer dritten Magnetfeldkomponente (B_{z}) bezüglich einer dritten Raumachse (z) und bezüglich des Referenzbereichs (12; 44);
wobei jede der magnetoresistiven Sensorelementeanordnungen als Brückenschaltung (34a-c) mit einer Mehrzahl von magnetoresistiven Sensorelementen (14a-d; 16a-d; 18a-d; 32a-d; 34a-d; 36a-d) angeordnet ist;
wobei die Raumachsen (x; y; z) entlang linear unabhängiger Ortsvektoren im Raum verlaufen; **dadurch gekennzeichnet, dass**
die Sensorelemente (14a-d; 16a-d; 18a-d; 32a-d; 34a-d; 36a-d) der Brückenschaltungen (34a-c) der ersten, zweiten und dritten magnetoresistiven Sensorelementeanordnung um eine gemeinsame Flächennormale angeordnete Wheatstone-Brücken mit paarweise jeweils unterschiedlicher magnetischer sensitiver Raumrichtung sind.

2. 3D Magnetfeldsensor gemäß Anspruch 1, bei dem die Brückenschaltungen (34a-c) von innen nach außen umschließend angeordnet sind.

3. 3D Magnetfeldsensor gemäß Anspruch 1 oder 2, bei dem jede der Brückenschaltungen (34a-c) als Vollbrückenschaltung ausgeführt ist, wobei jede der Vollbrückenschaltung symmetrisch bezüglich des Referenzbereichs (12; 44) angeordnet ist.

4. 3D Magnetfeldsensor gemäß einem der vorangehenden Ansprüche, bei dem jede der Sensorelementeanordnung einen geometrischen Mittelpunkt (22a-c; 22'a-c; 22"a-c) aufweist und jeder der geometrischen Mittelpunkte (22a-c; 22'a-c; 22"a-c) innerhalb des Referenzbereichs (12; 44) liegen.

5. 3D Magnetfeldsensor gemäß Anspruch 4, bei dem die geometrischen Mittelpunkte (22a-c; 22'a-c; 22"a-c) in eine Bildebene (48) projiziert deckungsgleich sind.

6. 3D Magnetfeldsensor gemäß einem der vorangehenden Ansprüche, bei dem die erste Brückenschaltung (34a), die zweite Brückenschaltung (34b) und die dritte Brückenschaltung (34c) in einer Ebene angeordnet sind.

7. 3D Magnetfeldsensor gemäß einem der vorangehenden Ansprüche, bei dem die Sensorelemente (14a-d; 16a-d; 18a-d; 32a-d; 34a-d; 36a-d) der Sensorelementeanordnungen elektrische Widerstandselemente sind und bei dem die Brückenschaltungen (34a-c) ausgebildet sind, um ein elektrisches Signal (U_{x,1}; U_{x,2}; U_{y,1}; U_{y,2}; U_{z,1}; U_{z,2}) basierend auf einem aus einem
variablen Riesenmagnetwiderstand (GMR);
variablen magnetischem Tunnelwiderstand (TMR); oder
einem variablen anisotropen magnetoresistiven Effekt (AMR)
bereitzustellen.

8. 3D Magnetfeldsensor (10; 20) zur Erfassung von drei räumlichen Magnetfeldkomponenten (Bₓ; B_{y}; B_{z}) in einem Referenzbereich (12; 44) mit folgenden Merkmalen:
einer ersten magnetoresistiven Sensorelementeanordnung (14a-d) zur Erfassung einer ersten Magnetfeldkomponente (Bₓ) bezüglich einer ersten Raumachse (x) und bezüglich des Referenzbereichs (12; 44);
einer zweiten magnetoresistiven Sensorelementeanordnung (16a-d) zur Erfassung einer zweiten Magnetfeldkomponente (B_{y}) bezüglich einer zweiten Raumachse (y) und bezüglich des Referenzbereichs (12; 44); und
einer dritten magnetoresistiven Sensorelementeanordnung (18a-d) zur Erfassung einer dritten Magnetfeldkomponente (B_{z}) bezüglich einer dritten Raumachse (z) und bezüglich des Referenzbereichs (12; 44);
wobei jede der magnetoresistiven Sensorelementeanordnungen als Brückenschaltung (34a-c) mit einer Mehrzahl von magnetoresistiven Sensorelementen (14a-d; 16a-d; 18a-d; 32a-d; 34a-d; 36a-d) angeordnet ist;
wobei die Raumachsen (x; y; z) entlang linear unabhängiger Ortsvektoren im Raum verlaufen;
wobei jede der Sensorelementeanordnung einen geometrischen Mittelpunkt (22a-c; 22'a-c; 22"a-c) aufweist und jeder der geometrischen Mittelpunkte (22a-c; 22'a-c; 22"a-c) innerhalb des Referenzbereichs (12; 44) liegen; **dadurch gekennzeichnet, dass** die geometrischen Mittelpunkte (22a-c; 22'a-c; 22"a-c) in eine Bildebene (48) projiziert deckungsgleich sind.

9. 3D Magnetfeldsensorsystem mit folgenden Merkmalen:
einem MxN Sensorarray (51; 51') aufweisend:
MxN 3D Magnetfeldsensoren (52a-c) gemäß einem der Ansprüche 1-8, die in Form einer Matrix mit M Zeilen und N Spalten angeordnet sind;
einem Substrat (62);
einer Ausleseschaltung (66);
einer Verbindungsstruktur (68), die mit dem MxN Sensorarray (51; 51') und der Ausleseschaltung (66) verbunden ist.

10. 3D Magnetfeldsensorsystem gemäß Anspruch 9, bei dem geometrische Mittelpunkte (22a-c; 22'a-c; 22"a-c) der Referenzbereiche (12; 44) der MxN 3D Magnetfeldsensoren (52a-c) bezüglich einer Ebene (x/y) mit einem Abstand (Δx; Δy) von weniger als 50 µm zueinander angeordnet sind.

11. 3D Magnetfeldsensorsystem gemäß Anspruch 9 oder 10, bei denen die Ausleseschaltung (66) und die MxN 3D Magnetfeldsensoren (52a-c) das gleiche Substrat (62) aufweisen.

12. 3D Magnetfeldsensorsystem gemäß einem der Ansprüche 9-11, das ferner eine Verarbeitungseinrichtung (56) aufweist, die ausgebildet ist, um elektrische Signale (U_{x,1}; U_{x,2}; U_{y,1}; U_{y,2}: U_{z,1}; U_{z,2}) von den Brückenschaltungen (34a-c) des Sensorarrays (51) zu empfangen und, um basierend auf den elektrischen Signalen (U_{x,1}; U_{x,2}; U_{y,1}; U_{y,2}; U_{z,1}; U_{z,2}) eine Information bezüglich der Magnetfeldorientierung (Bₓ; B_{y}; B_{z}) in den drei Raumachsen (x, y, z) für jeden der MxN 3D Magnetfeldsensoren (52a-c) bereitzustellen.

13. 3D Magnetfeldkamerasystem mit einem 3D Magnetfeldsensorsystem gemäß einem der Ansprüche 9-12, das eine Verarbeitungseinrichtung (56) aufweist, die ausgebildet ist, um elektrische Signale (U_{x,1}; U_{x,2}; U_{y,1}; U_{y,2}: U_{z,1}; U_{z,2}) von den Brückenschaltungen des Sensorarrays (51) zu empfangen und, um basierend auf den elektrischen Signalen (U_{x,1}; U_{x,2}; U_{y,1}; U_{y,2}: U_{z,1}; U_{z,2}) eine Information bezüglich der Magnetfeldorientierung (Bₓ; B_{y}; B_{z}) in den drei Raumachsen (x; y; z) für jeden der MxN 3D Magnetfeldsensoren (52a-c) bereitzustellen, wobei das 3D Magnetfeldkamerasystem ferner eine Anzeigeeinrichtung aufweist, die ausgebildet ist, um eine Magnetfeldorientierung (Bₓ; B_{y}; B_{z}) basierend auf der Information darzustellen.

14. Verfahren zum Herstellen eines 3D Magnetfeldsensors mit folgenden Schritten:
Bereitstellen eines Substrates (62);
Herstellen einer ersten magnetoresistiven Sensorelementeanordnung mit zumindest vier magnetoresistiven Sensorelementen (14a-d; 16a-d; 18a-d; 32a-d; 34a-d; 36a-d) in Form einer ersten Vollbrückenschaltung (34a) zur Erfassung einer ersten Magnetfeldkomponente (Bₓ) bezüglich einer ersten Raumachse (x) auf dem Substrat (62);
Herstellen einer zweiten magnetoresistiven Sensorelementeanordnung mit zumindest vier magnetoresistiven Sensorelementen (14a-d; 16a-d; 18a-d; 32a-d; 34a-d; 36a-d) in Form einer zweiten Vollbrückenschaltung (34b) zur Erfassung einer zweiten Magnetfeldkomponente (B_{y}) bezüglich einer zweiten Raumachse (y) auf dem Substrat (62);
Herstellen einer dritten magnetoresistiven Sensorelementeanordnung mit zumindest vier magnetoresistiven Sensorelementen (14a-d; 16a-d; 18a-d; 32a-d; 34a-d; 36a-d) in Form einer dritten Vollbrückenschaltung (34c) zur Erfassung einer dritten Magnetfeldkomponente (B_{z}) bezüglich einer dritten Raumachse (z) auf dem Substrat (62), wobei die Raumachsen (x; y; z) entlang linear unabhängiger Ortsvektoren im Raum verlaufen; und
wobei die Brückenschaltungen (34a-c) bei dem jeweiligen Schritt des Herstellens verschaltet werden,
**dadurch gekennzeichnet, dass** die Sensorelemente (14a-d; 16a-d; 18a-d; 32a-d; 34a-d;
36a-d) der Brückenschaltungen (34a-c) der ersten (14a-d), zweiten (16a-d) und dritten (18a-d) magnetoresistiven Sensorelementeanordnung um eine gemeinsame Flächennormale angeordnete Wheatstone-Brücken mit paarweise jeweils unterschiedlicher magnetischer sensitiver Raumrichtung sind.

15. 3D Magnetfeldsensorsystem mit folgenden Merkmalen:
einem MxN Sensorarray (51; 51') aufweisend:
MxN 3D Magnetfeldsensoren (52a-c), die in Form einer Matrix mit M Zeilen und N Spalten angeordnet sind; und
einem Substrat (62);
einer Ausleseschaltung (66); und
einer Verbindungsstruktur (68), die mit dem MxN Sensorarray (51; 51') und der Ausleseschaltung (66) verbunden ist;
wobei jeder Magnetfeldsensor (52a-c) ausgebildet ist, um drei räumlichen Magnetfeldkomponenten (Bₓ; B_{y}; B_{z}) in einem Referenzbereich (12; 44) zu erfassen und folgendes umfasst:
eine erste magnetoresistiven Sensorelementeanordnung (14a-d) zur Erfassung einer ersten Magnetfeldkomponente (Bₓ) bezüglich einer ersten Raumachse (x) und bezüglich des Referenzbereichs (12; 44);
eine zweite magnetoresistiven Sensorelementeanordnung (16a-d) zur Erfassung einer zweiten Magnetfeldkomponente (B_{y}) bezüglich einer zweiten Raumachse (y) und bezüglich des Referenzbereichs (12; 44); und
eine dritte magnetoresistiven Sensorelementeanordnung (18a-d) zur Erfassung einer dritten Magnetfeldkomponente (B_{z}) bezüglich einer dritten Raumachse (z) und bezüglich des Referenzbereichs (12; 44);
wobei jede der magnetoresistiven Sensorelementeanordnungen als Brückenschaltung (34a-c) mit einer Mehrzahl von magnetoresistiven Sensorelementen (14a-d; 16a-d; 18a-d; 32a-d; 34a-d; 36a-d) angeordnet ist;
wobei die Raumachsen (x; y; z) entlang linear unabhängiger Ortsvektoren im Raum verlaufen; **dadurch gekennzeichnet, dass** die Sensorelemente (14a-d; 16a-d; 18a-d; 32a-d; 34a-d; 36a-d) der Brückenschaltungen (34a-c) der ersten, zweiten und dritten magnetoresistiven Sensorelementeanordnung um eine gemeinsame Flächennormale angeordnete Wheatstone-Brücken mit paarweise jeweils unterschiedlicher magnetischer sensitiver Raumrichtung sind.

## Claims

1. 3D magnetic field sensor (10; 20) for capturing three spatial magnetic field components (Bx; By; Bz) in a reference area (12; 44), comprising:
a first magnetoresistive sensor element arrangement (14a-d) for capturing a first magnetic field component (Bₓ) with respect to a first spatial axis (x) and with respect to the reference area (12; 44);
a second magnetoresistive sensor element arrangement (16a-d) for capturing a second magnetic field component (B_{y}) with respect to a second spatial axis (y) and with respect to the reference area (12; 44); and
a third magnetoresistive sensor element arrangement (18a-d) for capturing a third magnetic field component (B_{z}) with respect to a third spatial axis (z) and with respect to the reference area (12; 44);
wherein each of the magnetoresistive sensor element arrangements is arranged as a bridge circuit (34a-c) with a plurality of magnetoresistive sensor elements (14a-d; 16a-d; 18a-d; 32a-d; 34a-d; 36a-d);
wherein the spatial axes (x; y; z) extend along linearly independent location vectors in the space; **characterized in that** the sensor elements (14a-d; 16a-d; 18a-d; 32a-d; 34a-d; 36a-d) of the bridge circuits (34a-c) of the first, second and third magnetoresistive sensor element arrangements are Wheatstone bridges arranged around a mutual surface normal, each having magnetic sensitive spatial directions that are different in pairs.

2. 3D magnetic field sensor according to claim 1, wherein the bridge circuits (34a-c) are arranged in an enclosing manner from the inside towards the outside.

3. 3D magnetic field sensor according to claim 1 or 2, wherein each of the bridge circuits (34a-c) is configured as a full bridge circuit, wherein each of the full bridge circuits is arranged in a symmetrical manner with respect to the reference area (12; 44).

4. 3D magnetic field sensor according to any one of the preceding claims, wherein each of the sensor element arrangements comprises a geometrical center (22a-c; 22'a-c; 22"a-c) and each of the geometrical centers (22a-c; 22'a-c; 22"a-c) is within the reference area (12; 44).

5. 3D magnetic field sensor according to claim 4, wherein the geometrical centers (22a-c; 22'a-c; 22"a-c) are congruent when projected into an image plane (48).

6. 3D magnetic field sensor according to any one of the preceding claims, wherein the first bridge circuit (34a), the second bridge circuit (34b) and the third bridge circuit (34c) are arranged in a plane.

7. 3D magnetic field sensor according to any one of the preceding claims, wherein the sensor elements (14a-d; 16a-d; 18a-d; 32a-d; 34a-d; 36a-d) of the sensor element arrangements are electrical resistance elements, and wherein the bridge circuits (34a-c) are configured to provide an electrical signal (U_{x,1}; U_{x,2}; U_{y,1}; U_{y,2}; U_{z,1}; U_{z,2}) based on the following:
a variable gigantic magnetoresistances (GMR);
a variable tunneling magnetoresistance (TMR); or
a variable anisotropic magnetoresistive effect (AMR).

8. 3D magnetic field sensor (10; 20) for capturing three spatial magnetic field components (Bₓ; B_{y}; B_{z}) in a reference area (12; 44), comprising:
a first magnetoresistive sensor element arrangement (14a-d) for capturing a first magnetic field component (Bₓ) with respect to a first spatial axis (x) and with respect to the reference area (12; 44);
a second magnetoresistive sensor element arrangement (16a-d) for capturing a second magnetic field component (B_{y}) with respect to a second spatial axis (y) and with respect to the reference area (12; 44); and
a third magnetoresistive sensor element arrangement (18a-d) for capturing a third magnetic field component (B_{z}) with respect to a third spatial axis (z) and with respect to the reference area (12; 44);
wherein each of the magnetoresistive sensor elements arrangements is arranged as a bridge circuit (34a-c) with a plurality of magnetoresistive sensor elements (14a-d; 16a-d; 18a-d; 32a-d; 34a-d; 36a-d);
wherein the spatial axes (x; y; z) extend along linearly independent location vectors in the space;
wherein each of the sensor element arrangements comprises a geometrical center (22a-c; 22'a-c; 22"a-c) and each of the geometrical centers (22a-c; 22'a-c; 22"a-c) is within the reference area (12; 44); **characterized in that** the geometrical centers (22a-c; 22'a-c; 22"a-c) are congruent when projected into an image plane (48).

9. 3D magnetic field sensor system, comprising:
a MxN sensor array (51; 51'), comprising:
MxN 3D magnetic field sensors (52a-c) according to any one of claims 1-8, arranged in the form of a matrix with M lines and N columns;
a substrate (62);
a readout circuit (66);
a connection structure (68), connected to the MxN sensor array (51; 51') and the readout circuit (66).

10. 3D magnetic field sensor according to claim 9, wherein geometrical centers (22a-c; 22'a-c; 22"a-c) of the reference areas (12; 44) of the MxN 3D magnetic field sensors (52a-c) are arranged with respect to a plane (x/y) in a distance (Δₓ; Δ_{y}) of less than 50 µm to each other.

11. 3D magnetic field sensor according to claim 9 or 10, wherein the readout circuit (66) and the MxN 3D magnetic field sensors (52a-c) comprise the same substrate (62).

12. 3D magnetic field sensor system according to any one of claims 9-11, further comprising a processing unit (56) configured to receive electrical signals (U_{x,1}; U_{x,2}; U_{y,1}; U_{y,2}; U_{z,1}; U_{z,2}) from the bridge circuits (34a-c) of the sensor array (51) and, based on the electrical signals (U_{x,1}; U_{x,2}; U_{y,1}; U_{y,2}; U_{z,1}; U_{z,2}), to provide information with respect to the magnetic field orientation (Bₓ; B_{y}; B_{z}) in the three spatial axes (x; y; z) for each of the MxN 3D magnetic field sensors (52a-c).

13. 3D magnetic field camera system having a 3D magnetic field sensor system according to any one of claims 9-12, comprising a processing unit (56) configured to receive electrical signals (U_{x,1}; U_{x,2}; U_{y,1}; U_{y,2}; U_{z,1}; U_{z,2}) from the bridge circuits of the sensor array (51) and, based on the electrical signals (U_{x,1}; U_{x,2}; U_{y,1}; U_{y,2}; U_{z,1}; U_{z,2}), to provide information with respect to the magnetic field orientation (Bₓ; B_{y}; B_{z}) in the three spatial axes (x; y; z) for each of the MxN 3D magnetic field sensors (52a-c), wherein the 3D magnetic field camera system further comprises a display unit configured to display a magnetic field orientation (Bₓ; B_{y}; B_{z}) based on the information.

14. Method for manufacturing a 3D magnetic field sensor, comprising:
providing a substrate (62);
manufacturing a first magnetoresistive sensor element arrangement with at least four magnetoresistive sensor elements (14a-d; 16a-d; 18a-d; 32a-d; 34a-d; 36a-d) in the form of a first full bridge circuit (34a) for capturing a first magnetic field component (Bₓ) with respect to a first spatial axis (x) on the substrate (62);
manufacturing a second magnetoresistive sensor element arrangement with at least four magnetoresistive sensor elements (14a-d; 16a-d; 18a-d; 32a-d; 34a-d; 36a-d) in the form of a second full bridge circuit (34b) for capturing a second magnetic field component (B_{y}) with respect to a second spatial axis (y) on the substrate (62);
manufacturing a third magnetoresistive sensor element arrangement with at least four magnetoresistive sensor elements (14a-d; 16a-d; 18a-d; 32a-d; 34a-d; 36a-d) in the form of a third full bridge circuit (34c) for capturing a third magnetic field component (B_{z}) with respect to a third spatial axis (z) on the substrate (62), wherein the spatial axes (x; y; z) extend along linearly independent location vectors in the space; and
wherein the bridge circuits (34a-c) are connected in the respective step of manufacturing,
**characterized in that** the sensor elements (14a-d; 16a-d; 18a-d; 32a-d; 34a-d; 36a-d) of the bridge circuits (34a-c) of the first (14a-d), second (16a-d) and third (18a-d) magnetoresistive sensor element arrangements are Wheatstone bridges arranged around a mutual surface normal, each having magnetic sensitive spatial directions that are different in pairs.

15. 3D magnetic field sensor system, comprising:
a MxN sensor array (51; 51'), comprising:
MxN 3D magnetic field sensors (52a-c) arranged in the form of a matrix with M lines and N columns; and
a substrate (62);
a readout circuit (66); and
a connection structure (68) connected to the MxN sensor array (51; 51') and the readout circuit (66);
wherein each magnetic field sensor (52a-c) is configured to capture three spatial magnetic field components (Bₓ; B_{y}; B_{z}) in a reference area (12; 44), and includes:
a first magnetoresistive sensor element arrangement (14a-d) for capturing a first magnetic field component (Bₓ) with respect to a first spatial axis (x) and with respect to the reference area (12; 44);
a second magnetoresistive sensor element arrangement (16a-d) for capturing a second magnetic field component (B_{y}) with respect to a second spatial axis (y) and with respect to the reference area (12; 44); and
a third magnetoresistive sensor element arrangement (18a-d) for capturing a third magnetic field component (B_{z}) with respect to a third spatial axis (z) and with respect to the reference area (12; 44);
wherein each of the magnetoresistive sensor elements arrangements is arranged as a bridge circuit (34a-c) with a plurality of magnetoresistive sensor elements (14a-d; 16a-d; 18a-d; 32a-d; 34a-d; 36a-d);
wherein the spatial axes (x; y; z) extend along linearly independent location vectors in the space;
**characterized in that** the sensor elements (14a-d; 16a-d; 18a-d; 32a-d; 34a-d; 36a-d) of the bridge circuit (34a-c) of the first, second and third magnetoresistive sensor element arrangements are Wheatstone bridges arranged around a mutual surface normal, each having magnetic sensitive spatial directions that are different in pairs.

## Revendications

1. Capteur de champ magnétique 3D (10; 20) pour détecter trois composantes de champ magnétique spatiales (Bₓ; B_{y}; B_{z}) dans une zone de référence (12; 44), aux caractéristiques suivantes:
un premier aménagement d'éléments de capteur magnéto-résistifs (14a à d) destiné à détecter une première composante de champ magnétique (Bₓ) par rapport à un premier axe spatial (x) et par rapport à la zone de référence (12; 44);
un deuxième aménagement d'éléments de capteur magnéto-résistifs (16a à d) destiné à détecter une deuxième composante de champ magnétique (B_{y}) par rapport à un deuxième axe spatial (y) et par rapport à la zone de référence (12; 44); et
un troisième aménagement d'éléments de capteur magnéto-résistifs (18a à d) destiné à détecter une troisième composante de champ magnétique (B_{z}) par rapport à un troisième axe spatial (z) et par rapport à la zone de référence (12; 44);
dans lequel chacun des aménagements d'éléments de capteur magnéto-résistifs est disposé sous forme de circuit en pont (34a à c) avec une pluralité d'éléments de capteur magnéto-résistifs (14a à d; 16a à d; 18a à d; 32a à d; 34a à d; 36a à d);
dans lequel les axes spatiaux (x; y; z) s'étendent le long de vecteurs de position linéairement indépendants dans l'espace;
**caractérisé par le fait que** les éléments de capteur (14a à d; 16a à d; 18a à d; 32a à d; 34a à d; 36a à d) des circuits en pont (34a à c) des premier, deuxième et troisième aménagements d'éléments de capteur magnéto-résistifs sont des ponts de Wheatstone disposés autour d'une normale à la surface commune respectivement à directions spatiales sensibles magnétiques différentes par paire.

2. Capteur de champ magnétique 3D selon la revendication 1, dans lequel les circuits en pont (34a à c) sont disposés de manière entourante de l'intérieur vers l'extérieur.

3. Capteur de champ magnétique 3D selon la revendication 1 ou 2, dans lequel chacun des circuits en pont (34a à c) est réalisé comme circuit en pont complet, où chacun des circuits en pont complet est disposé de manière symétrique par rapport à la zone de référence (12; 44).

4. Capteur de champ magnétique 3D selon l'une des revendications précédentes, dans lequel chacun des aménagements d'éléments de capteur présente un centre géométrique (22a à c; 22'a à c; 22"a à c) et chacun des centres géométriques (22a à c; 22'a à c; 22"a à c) se situe dans la zone de référence (12; 44).

5. Capteur de champ magnétique 3D selon la revendication 4, dans lequel les centres géométriques (22a à c; 22'a à c; 22"a à c) projetés dans un plan d'image (48) sont coextensifs.

6. Capteur de champ magnétique 3D selon l'une des revendications précédentes, dans lequel le premier circuit en pont (34a), le deuxième circuit en pont (34b) et le troisième circuit en pont (34c) sont disposés dans un même plan.

7. Capteur de champ magnétique 3D selon l'une des revendications précédentes, dans lequel les éléments de capteur (14a à d; 16a à d; 18a à d; 32a à d; 34a à d; 36a à d) des aménagements d'éléments de capteur sont des éléments de résistance électrique et dans lequel les circuits en pont (34a à c) sont conçus pour générer un signal électrique (U_{x,1}; U_{x,2}; U_{y,1}; U_{y,2}; U_{z,1}; U_{z,2}) sur base de l'un parmi
une magnétorésistance géante variable (GMR);
une résistance tunnel magnétique variable (TMR); ou
un effet magnéto-résistif anisotrope variable (AMR).

8. Capteur de champ magnétique 3D (10; 20) pour détecter trois composantes de champ magnétique spatiales (Bₓ; B_{y}; B_{z}) dans une zone de référence (12; 44), aux caractéristiques suivantes:
un premier aménagement d'éléments de capteur magnéto-résistifs (14a à d) destiné à détecter une première composante de champ magnétique (Bₓ) par rapport à un premier axe spatial (x) et par rapport à la zone de référence (12; 44);
un deuxième aménagement d'éléments de capteur magnéto-résistifs (16a à d) destiné à détecter une deuxième composante de champ magnétique (B_{y}) par rapport à un deuxième axe spatial (y) et par rapport à la zone de référence (12; 44); et
un troisième aménagement d'éléments de capteur magnéto-résistifs (18a à d) destiné à détecter une troisième composante de champ magnétique (B_{z}) par rapport à un troisième axe spatial (z) et par rapport à la zone de référence (12; 44);
dans lequel chacun des aménagements d'éléments de capteur magnéto-résistifs est disposé sous forme de circuit en pont (34a à c) avec une pluralité d'éléments de capteur magnéto-résistifs (14a à d; 16a à d; 18a à d; 32a à d; 34a à d; 36a à d);
dans lequel les axes spatiaux (x; y; z) s'étendent le long de vecteurs de position linéairement indépendants dans l'espace;
dans lequel chacun des aménagements d'éléments de capteur présente un centre géométrique (22a à c; 22'a à c; 22"a à c) et chacun des centres géométriques (22a à c; 22'a à c; 22"a à c) se situe dans la zone de référence (12; 44);
**caractérisé par le fait que** les centres géométriques ((22a à c; 22'a à c; 22"a à c) projetés dans un plan d'image (48) sont coextensifs.

9. Système de capteur de champ magnétique 3D aux caractéristiques suivantes:
présentant un réseau de capteurs MxN (51; 51'):
des capteurs de champ magnétique 3D MxN (52a à c) selon l'une des revendications 1 à 8 qui sont disposés sous forme d'une matrice à M rangées et N colonnes;
un substrat (62);
un circuit de lecture (66);
une structure de connexion (68) qui est connectée au réseau de capteurs MxN (51; 51') et au circuit de lecture (66).

10. Système de capteur de champ magnétique 3D selon la revendication 9, dans lequel les centres géométriques (22a à c; 22'a à c; 22"a à c) des zones de référence (12; 44) des capteurs de champ magnétique 3D MxN (52a à c) sont disposés par rapport à un plan (x/y) à une distance (Δx; Δy) de moins de 50 µm l'un de l'autre.

11. Système de capteur de champ magnétique 3D selon la revendication 9 ou 10, dans lequel le circuit de lecture (66) et les capteurs de champ magnétique 3D MxN (52a à c) présentent le même substrat (62).

12. Système de capteur de champ magnétique 3D selon l'une des revendications 9 à 11, présentant par ailleurs un moyen de traitement (56) qui est conçu pour recevoir des signaux électriques (U_{x,1}; U_{x,2}; U_{y,1}; U_{y,2}: U_{z,1}; U_{z,2}) des circuits en pont (34a à c) du réseau de capteurs (51) et pour mettre à disposition, sur base des signaux électriques (U_{x,1}; U_{x,2}; U_{y,1}; U_{y,2}: U_{z,1}; U_{z,2}), une information relative à l'orientation de champ magnétique (Bₓ; B_{y}; B_{z}) dans les trois axes spatiaux (x, y, z) pour chacun des capteurs de champ magnétique 3D MxN (52a à c).

13. Système de caméra à champ magnétique 3D avec un système de capteur de champ magnétique 3D selon l'une des revendications 9 à 12 qui présente un dispositif de traitement (56) qui est conçu pour recevoir des signaux électriques (U_{x,1}; U_{x,2}; U_{y,1}; U_{y,2}: U_{z,1}; U_{z,2}) des circuits en pont du réseau de capteurs (51) et pour mettre à disposition, sur base des signaux électriques (U_{x,1}; U_{x,2}; U_{y,1}; U_{y,2}: U_{z,1}; U_{z,2}), une information relative à l'orientation de champ magnétique (Bₓ; B_{y}; B_{z}) dans les trois axes spatiaux (x; y; z) pour chacun des capteurs de champ magnétique 3D MxN (52a à c), dans lequel le système de caméra de champ magnétique 3D présente par ailleurs un moyen d'affichage qui est conçu pour représenter une orientation de champ magnétique (Bₓ; B_{y}; B_{z}) sur base de l'information.

14. Procédé de fabrication d'un capteur de champ magnétique 3D aux étapes suivantes consistant à:
prévoir un substrat (62);
réaliser un premier aménagement d'éléments de capteur magnéto-résistifs avec au moins quatre éléments de capteur magnéto-résistifs (14a à d; 16a à d; 18a à d; 32a à d; 34a à d; 36a à d) sous forme d'un premier circuit en pont complet (34a) destiné à détecter une première composante de champ magnétique (Bₓ) par rapport à un premier axe spatial (x) sur le substrat (62);
réaliser un deuxième aménagement d'éléments de capteur magnéto-résistifs avec au moins quatre éléments de capteur magnéto-résistifs (14a à d; 16a à d; 18a à d; 32a à d; 34a à d; 36a à d) sous forme d'un deuxième circuit en pont complet (34b) destiné à détecter une deuxième composante de champ magnétique (B_{y}) par rapport à un deuxième axe spatial (y) sur le substrat (62);
réaliser un troisième aménagement d'éléments de capteur magnéto-résistifs avec au moins quatre éléments de capteur magnéto-résistifs (14a à d; 16a à d; 18a à d; 32a à d; 34a à d; 36a à d) sous forme d'un troisième circuit en pont complet (34c) destiné à détecter une troisième composante de champ magnétique (B_{z}) par rapport à un troisième axe spatial (z) sur le substrat (62), où les axes spatiaux (x; y; z) s'étendent le long de vecteurs de position linéairement indépendants dans l'espace; et
dans lequel les circuits en pont (34a à c) sont câblés à l'étape de fabrication respective,
**caractérisé par le fait**
**que** les éléments de capteur (14a à d; 16a à d; 18a à d; 32a à d; 34a à d; 36a à d) des circuits en pont (34a à c) des premier (14a à d), deuxième (16a à d) et troisième (18a à d) aménagements d'éléments de capteur magnéto-résistifs sont des ponts de Wheatstone disposés autour d'une normale à la surface commune respectivement à directions spatiales sensibles magnétiques différentes par paire.

15. Système de capteur de champ magnétique 3D, aux caractéristiques suivantes:
un réseau de capteurs MxN (51; 51') présentant:
des capteurs de champ magnétique 3D MxN (52a à c) disposés sous forme d'une matrice à M lignes et N colonnes; et
un substrat (62);
un circuit de lecture (66); et
une structure de connexion (68) qui est connectée au réseau de capteurs MxN (51; 51') et au circuit de lecture (66);
dans lequel chaque capteur de champ magnétique (52a à c) est conçu pour détecter trois composantes de champ magnétique spatiales (Bₓ; B_{y}; B_{z}) dans une zone de référence (12; 44) et comporte ce qui suit:
un premier aménagement d'éléments de capteur magnéto-résistifs (14a à d) destiné à détecter une première composante de champ magnétique (Bₓ) par rapport à un premier axe spatial (x) et par rapport à la zone de référence (12; 44);
un deuxième aménagement d'éléments de capteur magnéto-résistifs (16a à d) destiné à détecter une deuxième composante de champ magnétique (B_{y}) par rapport à un deuxième axe spatial (y) et par rapport à la zone de référence (12; 44); et
un troisième aménagement d'éléments de capteur magnéto-résistifs (18a à d) destiné à détecter une troisième composante de champ magnétique (B_{z}) par rapport à un troisième axe spatial (z) et par rapport à la zone de référence (12; 44);
dans lequel chacun des aménagements d'éléments de capteur magnéto-résistifs est disposé sous forme de circuit en pont (34a à c) avec une pluralité d'éléments de capteur magnéto-résistifs (14a à d; 16a à d; 18a à d; 32a à d; 34a à d; 36a à d);
dans lequel les axes spatiaux (x; y; z) s'étendent le long de vecteurs de position linéairement indépendants dans l'espace;
**caractérisé par le fait que** les éléments de capteur (14a à d; 16a à d; 18a à d; 32a à d; 34a à d; 36a à d) des circuits en pont (34a à c) des premier, deuxième et troisième aménagements d'éléments de capteur magnéto-résistifs sont des ponts de Wheatstone disposés autour d'une normale à la surface commune respectivement à directions spatiales sensibles magnétiques différentes par paire.
